# EUROPEAN PATENT APPLICATION

(11) **EP 4 492 456 A2**
(43) Date of publication of application: **15.01.2025**
(21) Application number: 24178759.7
(22) Date of filing: 29.05.2024
(51) Int. Cl.: H01L 23/482, H01L 29/423, H01L 29/66, H01L 29/778

(54) **SEMICONDUCTOR DEVICE AND ELECTRONIC APPARATUS INCLUDING THE SAME**

(30) Priority: 10.07.2023 KR 20230089050
(71) Applicant: Samsung Electronics Co., Ltd., Suwon-si, Gyeonggi-do 16677 (KR); Foundation Of Soongsil University-Industry Cooperation, Seoul 06978 (KR)
(72) Inventor: OH, Youngtek, 16678 Suwon-si (KR); YOO, Geonwook, 06978 Dongjak-gu (KR); HWANG, Kyungwook, 16678 Suwon-si (KR); PARK, Changkun, 06978 Dongjak-gu (KR); SONG, Sanghoon, 16678 Suwon-si (KR); YEOM, Minjae, 06978 Dongjak-gu (KR); LEE, Gyuhyung, 06978 Dongjak-gu (KR); HWANG, Junsik, 16678 Suwon-si (KR)
(74) Representative: Elkington and Fife LLP

(57) **Abstract**

A semiconductor device includes a channel layer including a first group III-V semiconductor material; a barrier layer provided on an upper surface of the channel layer, the barrier layer including a second group III-V semiconductor material that is different than the first group III-V semiconductor material; a plurality of sources/drains spaced apart from each other on an upper surface of the barrier layer; a gate insulating layer covering the upper surface of the barrier layer and upper surfaces of the plurality of sources/drains; a gate provided on an upper surface of the gate insulating layer, the gate not overlapping the plurality of sources/drains; a plurality of source/drain electrodes electrically connected to corresponding sources/drains among the plurality of sources/drains; and a gate electrode electrically connected to the gate, wherein the plurality of source/drain electrodes has a diagonally symmetrical arrangement.

## Description

### FIELD OF THE INVENTION

Embodiments of the disclosure relate to a semiconductor device and an electronic apparatus including the same.

### BACKGROUND OF THE INVENTION

Various types of power conversion systems require a device that controls the flow of current through ON/OFF switching, that is, a power device. In a power conversion system, the efficiency of a power device may determine the efficiency of the entire system. As a switching device, a power metal-oxide-semiconductor field-effect transistor (MOSFET) or an insulated-gate bipolar transistor (IGBT) using silicon (Si) is generally used, but there is a limit to increasing the efficiency of the switching device due to material limitations of Si itself. In an attempt to overcome the material limitations of Si, research on high-electron-mobility transistors (HEMTs) using heterojunction structures of compound semiconductors has been actively conducted.

However, because HEMTs are mainly group III-V semiconductor devices, it is difficult to manufacture an HEMT on a group IV semiconductor substrate including Si. Accordingly, an electronic apparatus is manufactured by separately manufacturing an HEMT including a group III-V semiconductor and a semiconductor device including Si, and then wire bonding the HEMT and the semiconductor device on a printed circuit board (PCB). This can increase the cost and complexity of the manufacturing process.

### SUMMARY OF THE INVENTION

Provided are a group III-V semiconductor device having an electrode structure suitable for transfer by a fluidic self-assembly (FSA) transfer method and an electronic apparatus including the semiconductor device.

Additional aspects will be set forth in part in the description which follows and, in part, will be apparent from the description, or may be learned by practice of the presented embodiments.

According to an aspect of an embodiment, a semiconductor device includes: a channel layer including a first group III-V semiconductor material; a barrier layer provided on an upper surface of the channel layer, the barrier layer including a second group III-V semiconductor material that is different than the first group III-V semiconductor material; a plurality of sources/drains spaced apart from each other on an upper surface of the barrier layer; a gate insulating layer covering the upper surface of the barrier layer and upper surfaces of the plurality of sources/drains; a gate provided on an upper surface of the gate insulating layer, the gate not overlapping the plurality of sources/drains; a plurality of source/drain electrodes electrically connected to corresponding sources/drains among the plurality of sources/drains; and a gate electrode electrically connected to the gate, wherein the plurality of source/drain electrodes has a diagonally symmetrical arrangement.

The plurality of sources/drains may include: a first source/drain provided on a first quadrant of the upper surface of the barrier layer, a second source/drain provided on a second quadrant of the upper surface of the barrier layer, a third source/drain provided on a third quadrant of the upper surface of the barrier layer, and a fourth source/drain provided on a fourth quadrant of the upper surface of the barrier layer.

The first source/drain, the second source/drain, the third source/drain, and the fourth source/drain may not cover a central area of the upper surface of the barrier layer.

The first source/drain and the fourth source/drain may have a symmetrical shape with respect to a boundary between the first quadrant and the fourth quadrant, the first source/drain and the second source/drain may have a symmetrical shape with respect to a boundary between the first quadrant and the second quadrant, the second source/drain and the third source/drain may have a symmetrical shape with respect to a boundary between the second quadrant and the third quadrant, and the third source/drain and the fourth source/drain may have a symmetrical shape with respect to a boundary between the third quadrant and the fourth quadrant.

The semiconductor device may further include: a first conductive layer provided on the upper surface of the gate insulating layer and electrically connected to the first source/drain; a second conductive layer provided on the upper surface of the gate insulating layer and electrically connected to the second source/drain; a third conductive layer provided on the upper surface of the gate insulating layer and electrically connected to the third source/drain; and a fourth conductive layer provided on the upper surface of the gate insulating layer and electrically connected to the fourth source/drain.

The first conductive layer may be in a vertex area of the first quadrant on the upper surface of the gate insulating layer, the second conductive layer may be in a vertex area of the second quadrant on the upper surface of the gate insulating layer, the third conductive layer may be in a vertex area of the third quadrant on the upper surface of the gate insulating layer, and the fourth conductive layer may be in a vertex area of the fourth quadrant on the upper surface of the gate insulating layer.

The gate insulating layer may include a plurality of openings that expose a portion of an upper surface of each of the first source/drain, the second source/drain, the third source/drain, and the fourth source/drain, and the first conductive layer, the second conductive layer, the third conductive layer, and the fourth conductive layer may contact, through the plurality of openings, with the first source/drain, the second source/drain, the third source/drain, and the fourth source/drain, respectively.

The plurality of source/drain electrodes may include: a first source/drain electrode electrically connected to the first source/drain, a second source/drain electrode electrically connected to the second source/drain, a third source/drain electrode electrically connected to the third source/drain, and a fourth source/drain electrode electrically connected to the fourth source/drain.

The gate electrode may be in a central portion of the semiconductor device, the first source/drain electrode and the third source/drain electrode may face each other in a first diagonal direction and are a first distance from a center of the gate electrode, the second source/drain electrode and the fourth source/drain electrode may face each other in a second diagonal direction and are a second distance from the center of the gate electrode, the second diagonal direction crosses the first diagonal direction, and the second distance is different from the first distance.

The gate may include: a central gate arranged in a central portion of the upper surface of the gate insulating layer; and a plurality of branch gates extending between two adjacent sources/drains among the plurality of sources/drains.

Each of the plurality of branch gates may have a serpentine curve shape.

Each of the plurality of branch gates may have a straight line shape.

The gate insulating layer may cover a sidewall of the barrier layer and a sidewall of the channel layer.

Each of the plurality of branch gates may extend along a surface of the gate insulating layer to face the sidewall of the barrier layer and the sidewall of the channel layer.

The semiconductor device may further include a passivation layer configured to cover the gate insulating layer and the gate, and the gate electrode and the plurality of source/drain electrodes may pass through the passivation layer.

The plurality of sources/drains may include a first source/drain, a second source/drain, and a third source/drain that extend in a first direction, the first source/drain, the second source/drain, and the third source/drain may be sequentially arranged in a second direction that is perpendicular to the first direction, and the gate may include: a first branch gate extending in the first direction between the first source/drain and the second source/drain; and a second branch gate extending in the first direction between the second source/drain and the third source/drain.

According to an aspect of the disclosure, an electronic apparatus includes: a substrate including a first semiconductor material; a first semiconductor device provided on the substrate; and a second semiconductor device provided on the substrate and including a second semiconductor material that is different than the first semiconductor material, wherein the second semiconductor device includes: a channel layer including a first group III-V semiconductor material; a barrier layer provided on an upper surface of the channel layer, the barrier layer including a second group III-V semiconductor material that is different than the first group III-V semiconductor material; a plurality of sources/drains spaced apart from each other on an upper surface of the barrier layer; a gate insulating layer covering the upper surface of the barrier layer and upper surfaces of the plurality of sources/drains; a gate provided on an upper surface of the gate insulating layer, the gate not overlapping the plurality of sources/drains; a plurality of source/drain electrodes electrically connected to corresponding sources/drains among the plurality of sources/drains; and a gate electrode electrically connected to the gate, and wherein the plurality of source/drain electrodes has a diagonally symmetrical arrangement.

The first semiconductor device may be one of a transistor, a light-emitting device, or a sensor device.

The substrate may include a recessed groove in an upper surface of the substrate, and the second semiconductor device may be provided in the groove such that the gate electrode and the plurality of source/drain electrodes face an outside of the groove.

The gate electrode and the plurality of source/drain electrodes may face an upper surface of the substrate.

### BRIEF DESCRIPTION OF THE DRAWINGS

The above and other aspects, features, and advantages of certain embodiments will be more apparent from the following description taken in conjunction with the accompanying drawings, in which:
FIG. 1 is a plan view illustrating an example of an electrode arrangement of a semiconductor device, according to an embodiment;
FIG. 2A is a schematic cross-sectional view of a structure of a semiconductor device taken along a line A-A' of FIG. 1;
FIG. 2B is a schematic cross-sectional view of a structure of a semiconductor device taken along a line B-B' of FIG. 1;
FIG. 2C is a schematic cross-sectional view of a structure of a semiconductor device taken along a line C-C' of FIG. 1;
FIG. 3 is a schematic plan view of an electrode arrangement structure of a semiconductor device shown in FIG. 1;
FIG. 4 is a plan view illustrating an example of a shape of a gate in a semiconductor device, according to another embodiment;
FIGS. 5A to 5L are views illustrating an example of a process of manufacturing the semiconductor device shown in FIG. 1;
FIGS. 6A to 6F are views illustrating an example of a process of manufacturing an electronic apparatus by integrating the semiconductor device shown in FIG. 1 on a heterogeneous semiconductor substrate;
FIG. 7 is a plan view illustrating an example of an arrangement of a plurality of electrode pads included in a resulting electronic apparatus;
FIGS. 8A to 8C are views illustrating an example of a process of fluidic self-assembly (FSA) transfer of the semiconductor device shown in FIG. 1 onto a heterogeneous semiconductor substrate;
FIGS. 9A to 9C are views illustrating examples of various wiring patterns for electrical connection with the semiconductor device shown in FIG. 1 in an electronic apparatus, according to an embodiment;
FIG. 10 is a circuit diagram illustrating an example of an equivalent circuit of an electronic apparatus, according to an embodiment;
FIGS. 11A and 11B are views illustrating an example of a process of manufacturing an electronic apparatus by transferring a semiconductor device onto a heterogeneous semiconductor substrate through a separate transfer substrate;
FIG. 12 is a plan view illustrating an example of an electrode arrangement of a semiconductor device, according to another embodiment; and
FIGS. 13A and 13B are views illustrating examples of wiring patterns for electrical connection with a semiconductor device in an electronic apparatus including the semiconductor device shown in FIG. 12.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a semiconductor device and an electronic apparatus including the same will be described in detail with reference to the accompanying drawings. In the following drawings, the same reference numerals refer to the same elements, and the size of each element in the drawings may be exaggerated for convenience of description. Also, embodiments described below are merely illustrative, and various modifications may be made from these embodiments.

Hereinafter, when an element is referred to as being "on", "above", or "over" another element, it can be directly on the other element in contact with the other element, or indirectly above or over the other element without contact with the other element. The singular forms "a," "an," and "the" as used herein are intended to include the plural forms as well unless the context clearly indicates otherwise. Also, it will be understood that when a portion is referred to as "including" another element, it may not exclude the other element but may further include the other element unless otherwise described.

The use of the term "the" and similar referential terms may refer to both the singular and the plural expressions. Unless an order is specifically stated or stated to the contrary, operations constituting a method may be performed in any appropriate order and are not necessarily limited to the specified order.

In addition, the terms "...or/er" or "module" used herein refer to a unit that processes at least one function of operation, which may be implemented as hardware or software, or as a combination of hardware and software.

Connections of lines or connection members between elements shown in the drawings illustratively represent functional connections and/or physical or circuit connections, and in an actual apparatus, they may appear as various types of alternative or additional functional, physical, or circuit connections.

The use of all examples or illustrative terms is simply for explaining the technical idea in detail, and the scope of the disclosure is not limited by the examples or illustrative terms unless limited by the claims.

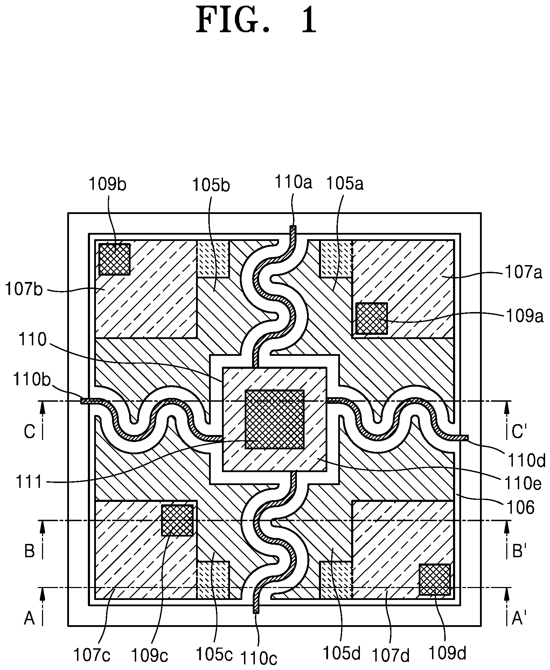

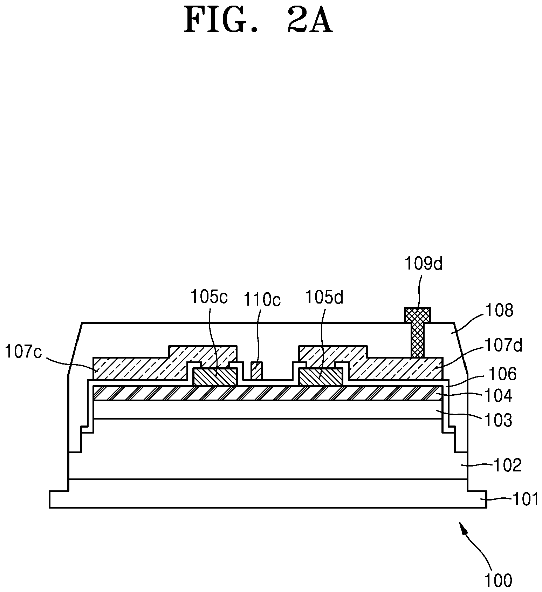

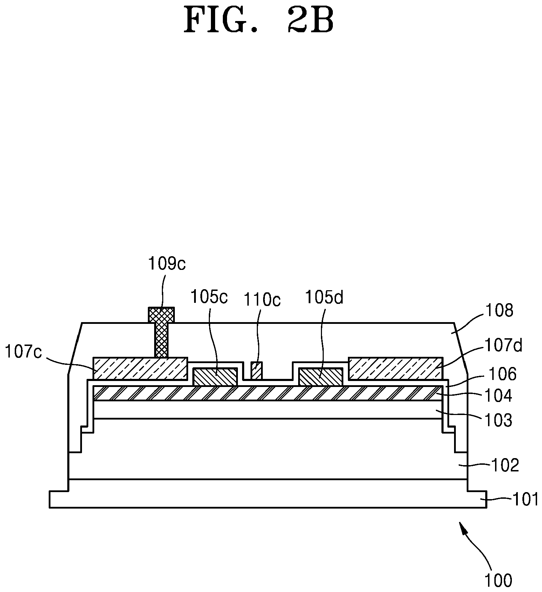

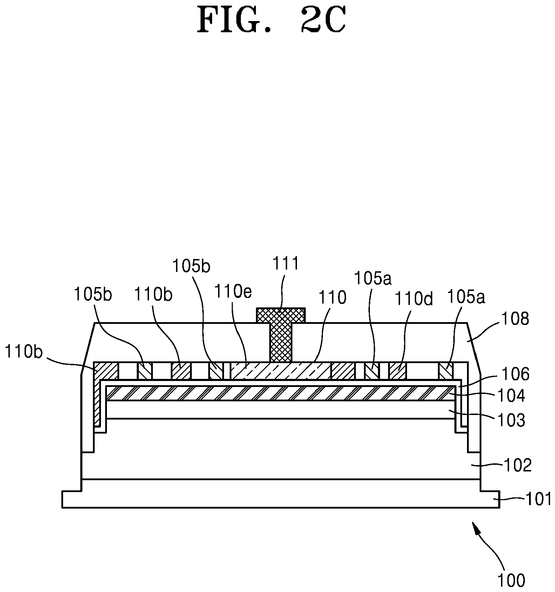

FIG. 1 is a plan view illustrating an example of an electrode arrangement of a semiconductor device, according to an embodiment, FIG. 2A is a schematic cross-sectional view of a structure of a semiconductor device taken along a line A-A' of FIG. 1, FIG. 2B is a schematic cross-sectional view of a structure of a semiconductor device taken along a line B-B' of FIG. 1, and FIG. 2C is a schematic cross-sectional view of a structure of a semiconductor device taken along a line C-C' of FIG. 1. In order to show an arrangement relationship between a plurality of sources/drains 105a, 105b, 105c, and 105d, a plurality of conductive layers 107a, 107b, 107c, and 107d, a plurality of source/drain electrodes 109a, 109b, 109c, and 109d, a gate 110, and a gate electrode 111, all of which will be described below, FIG. 1 is illustrated assuming that a gate insulating layer 106 and a passivation layer 108, which will be described below, are transparent for convenience of description. However, the gate insulating layer 106 and the passivation layer 108 do not actually need to be transparent.

Referring to FIGS. 1, 2A, 2B, and 2C, a semiconductor device 100 according to an embodiment may include a substrate 101, a buffer layer 102 provided on the substrate 101, a channel layer 103 provided on the buffer layer 102, a barrier layer 104 provided on the channel layer 103, the plurality of sources/drains 105a, 105b, 105c, and 105d provided on the barrier layer 104, the gate insulating layer 106 provided to cover surfaces of the channel layer 103 and the barrier layer 104, the gate 110 provided on the gate insulating layer 106, the plurality of conductive layers 107a, 107b, 107c, and 107d provided on the gate insulating layer 106 to be electrically connected to the plurality of sources/drains 105a, 105b, 105c, and 105d, respectively, the passivation layer 108 provided to cover the gate insulating layer 106, the gate 110, and the plurality of conductive layers 107a, 107b, 107c, and 107d to protect the semiconductor device 100, the plurality of source/drain electrodes 109a, 109b, 109c, and 109d provided to be electrically connected to the plurality of conductive layers 107a, 107b, 107c, and 107d through the passivation layer 108, respectively, and the gate electrode 111 provided to be electrically connected to the gate 110 through the passivation layer 108.

The semiconductor device 100 may include a group III-V semiconductor device including a group III-V semiconductor material. For example, the semiconductor device 100 may include a high-electron-mobility transistor (HEMT).

The substrate 101 may be a growth substrate for manufacturing the semiconductor device 100. The substrate 101 shown in FIG. 2A may be removed prior to fluidic self-assembly (FSA) transfer of the semiconductor device 100, which will be described below. To this end, the substrate 101 may include a material that may be easily separated from the buffer layer 102 by using a chemical lift-off method or a laser lift-off method. For example, the substrate 101 may include at least one of sapphire and silicon (Si), but is not limited thereto. The substrate 101 may also various other materials capable of chemical lift-off or laser lift-off. When the substrate 101 is separated using the chemical lift-off or laser-lift off method, a lower surface of the semiconductor device 100, that is, a lower surface of the buffer layer 102, may be in a very smooth and flat state.

The buffer layer 102 may be provided to prevent the crystallinity of the channel layer 103 from deteriorating by alleviating a difference in lattice constant and thermal expansion coefficient between the substrate 101 and the channel layer 103. The buffer layer 102 may have a single-layer or multilayer structure including one or more materials selected from group III-V materials, for example, nitrides including at least one of aluminum (Al), gallium (Ga), and indium (In). The buffer layer 102 may be AlₓIn_{y}Ga_{1-x-y}N (0≤x≤1, 0≤y≤1, x+y≤1). The buffer layer 102 may have a single-layer or multilayer structure including at least one of aluminum nitride (AIN), gallium nitride (GaN), aluminum gallium nitride (AlGaN), indium gallium nitride (InGaN), aluminum indium nitride (AlInN), and aluminum gallium indium nitride (AlGaInN). Also, when necessary, a seed layer for growth of the buffer layer 102 may be further provided between the substrate 101 and the buffer layer 102.

The channel layer 103 may be a layer forming a channel between a source and a drain and may include a material capable of generating a two-dimensional electron gas (2DEG) therein. The channel layer 103 may have a single-layer or multilayer including one or more materials selected from the group III-V materials, for example, nitrides including at least one of Al, Ga, and In. The channel layer 103 may be AlₓIn_{y}Ga_{1-x-y}N (0≤x≤1, 0≤y≤1, x+y≤1). For example, the channel layer 103 may include at least one material among GaN, AlN, indium nitride (InN), InGaN, AlGaN, AlInN, and aluminum indium gallium nitride (AlInGaN). The channel layer 103 may be an undoped layer or a layer doped with impurities. A thickness of the channel layer 103 may be several hundred nm or less.

The barrier layer 104 may include a group III-V semiconductor material that is different from a semiconductor material of the channel layer 103. For example, the barrier layer 104 may be different from the channel layer 103 in at least one of polarization characteristics, energy bandgap, and lattice constant. The barrier layer 104 may include a material having an energy bandgap greater than that of the channel layer 103. For example, the barrier layer 104 may have a multilayer structure including one or more materials selected from group III-V semiconductor materials, for example, nitrides including at least one of Al, Ga, and In. The barrier layer 104 may be, for example, AlₓIn_{y}Ga_{1-x-y}N (0≤x≤1, 0≤y≤1, x+y≤1) and may include at least one material among GaN, InN, AlGaN, AlInN, InGaN, AIN, and AlInGaN. An energy band gap of the barrier layer 104 may be adjusted by a composition ratio of Al and/or In.

The barrier layer 104 may be doped with a certain impurity. The impurity may be a p-type dopant that may provide a hole. For example, magnesium (Mg) may be used as a p-type dopant. A doping concentration of the barrier layer 104 may be set to obtain a predetermined threshold voltage and on-resistance.

The barrier layer 104 may have a relatively greater energy band gap than that of the channel layer 103 and may have a higher electrical polarization rate than that of the channel layer 103. Accordingly, the barrier layer 104 may induce a 2DEG in the channel layer 103, which may have a relatively low electrical polarization rate. In this regard, the barrier layer 104 may also be referred to as a channel supply layer or a 2DEG supply layer. The 2DEG may be formed in an area of the channel layer 103 under an interface between the channel layer 103 and the barrier layer 104. The 2DEG exhibits very high electron mobility.

Accordingly, an area of the channel layer 103 facing the barrier layer 104 becomes a drift area. The drift area may be an area formed in the channel layer 103 between the source and the drain, and may be an area where carrier movement occurs when a potential difference is generated between the source and the drain. Carrier movement in the drift area may be allowed/blocked or controlled according to the magnitude of a voltage applied to the gate 110.

In FIG. 2A, the barrier layer 104 is shown as a single layer, but may include a plurality of layers. The barrier layer 104 may include, for example, a plurality of layers having different energy band gaps, and the plurality of layers may be arranged such that an energy band gap of a layer closer to the channel layer 103 among the plurality of layers is greater.

The plurality of sources/drains 105a, 105b, 105c, and 105d including conductive metal may be provided on an upper surface of the barrier layer 104 and spaced apart from each other. In FIG. 1, four sources/drains 105a, 105b, 105c, and 105d are shown. For example, the semiconductor device 100 may include a first source/drain 105a, a second source/drain 105b, a third source/drain 105c, and a fourth source/drain 105d. However, the number of sources/drains 105a, 105b, 105c, and 105d is not limited thereto, and three or more sources/drains may be selected.

The upper surface of the barrier layer 104 may have a square shape. The first to fourth sources/drains 105a, 105b, 105c, and 105d may be arranged in four quadrant areas on the upper surface of the barrier layer 104, respectively. For example, the first source/drain 105a, the second source/drain 105b, the third source/drain 105c, and the fourth source/drain 105d may be arranged on a first quadrant area, a second quadrant area, a third quadrant area, and a fourth quadrant area on the upper surface of the barrier layer 104, respectively.

Also, as shown in FIG. 1, the first to fourth sources/drains 105a, 105b, 105c, and 105d may be arranged avoiding a central area on the upper surface of the barrier layer 104, areas near four vertices, and an area between two adjacent quadrant areas. For example, the first source/drain 105a may be arranged to cover areas on the first quadrant area of the upper surface of the barrier layer 104, except for a central area on the upper surface of the barrier layer 104, areas near vertices of the first quadrant area, a boundary area between the first quadrant area and the fourth quadrant area, and a boundary area between the first quadrant area and the second quadrant area. The second source/drain 105b may be arranged to cover areas on the second quadrant area of the upper surface of the barrier layer 104, except for a central area on the upper surface of the barrier layer 104, areas near vertices of the second quadrant area, a boundary area between the second quadrant area and the third quadrant area, and a boundary area between the second quadrant area and the first quadrant area. The third source/drain 105c may be arranged to cover areas on the third quadrant area of the upper surface of the barrier layer 104, except for a central area on the upper surface of the barrier layer 104, areas near vertices of the third quadrant area, a boundary area between the third quadrant area and the second quadrant area, and a boundary area between the third quadrant area and the fourth quadrant area. The fourth source/drain 105d may be arranged to cover areas on the fourth quadrant area of the upper surface of the barrier layer 104, except for a central area on the upper surface of the barrier layer 104, areas near vertices of the fourth quadrant area, a boundary area between the fourth quadrant area and the first quadrant area, and a boundary area between the fourth quadrant area and the third quadrant area.

Also, two adjacent source/drains of the first to fourth sources/drains 105a, 105b, 105c, and 105d may be symmetrical with respect to a boundary therebetween. For example, the first source/drain 105a and the fourth source/drain 105d may have a symmetrical shape with respect to a boundary between the first quadrant area and the fourth quadrant area. The first source/drain 105a and the second source/drain 105b may have a symmetrical shape with respect to a boundary between the first quadrant area and the second quadrant area. The second source/drain 105b and the third source/drain 105c may have a symmetrical shape with respect to a boundary between the second quadrant area and the third quadrant area. The third source/drain 105c and the fourth source/drain 105d may have a symmetrical shape with respect to a boundary between the third quadrant area and the fourth quadrant area. Also, when viewed from the top, the first to fourth sources/drains 105a, 105b, 105c, and 105d may have a symmetrical shape with respect to the center of the semiconductor device 100.

The gate insulating layer 106 may be provided to cover the upper surface of the barrier layer 104. The gate insulating layer 106 may include, for example, at least one oxide material among silicon oxide (SiO₂), hafnium oxide (HfOₓ), and aluminum oxide (Al₂O₃), but is not limited thereto. The gate insulating layer 106 may extend to cover a sidewall of the barrier layer 104, a sidewall of the channel layer 103, and a portion of a sidewall of the buffer layer 102. Also, the gate insulating layer 106 may be provided to cover sidewalls and upper surfaces of the first to fourth sources/drains 105a, 105b, 105c, and 105d. For electrical connection between the conductive layers 107a, 107b, 107c, and 107d to be described below and the first to fourth sources/drains 105a, 105b, 105c, and 105d, as shown in FIG. 2A, the gate insulating layer 106 may be removed from a portion of the first to fourth sources/drains 105a, 105b, 105c, and 105d. For example, a portion of the upper surfaces of the first to fourth sources/drains 105a, 105b, 105c, and 105d may be exposed and not be covered by the gate insulating layer 106. However, remaining areas of the upper surfaces of the first to fourth sources/drains 105a, 105b, 105c, and 105d may be covered by the gate insulating layer 106, as shown in FIG. 2B.

The gate 110 including a conductive metal may be provided on the gate insulating layer 106. As shown in FIG. 1, when viewed from the top, the gate 110 may be arranged on an upper surface of the gate insulating layer 106 not to overlap the first to fourth sources/drains 105a, 105b, 105c, and 105d. Also, the gate 110 may include a central gate 110e arranged in a central portion of the semiconductor device 100 or in a central portion of the upper surface of the gate insulating layer 106, and a plurality of branch gates 110a, 110b, 110c, and 110d extending from the central gate 110e to between two adjacent sources/drains of the first to fourth sources/drains 105a, 105b, 105c, and 105d. For example, the gate 110 may include a first branch gate 110a extending in a serpentine curve from the central gate 110e to between the first source/drain 105a and the second source/drain 105b or along the boundary between the first quadrant area and the second quadrant area, a second branch gate 110b extending in a serpentine curve from the central gate 110e to between the second source/drain 105b and the third source/drain 105c or along the boundary between the second quadrant area and the third quadrant area, a third branch gate 110c extending in a serpentine curve from the central gate 110e to between the third source/drain 105c and the fourth source/drain 105d or along the boundary between the third quadrant area and the fourth quadrant area, and a fourth branch gate 110d extending in a serpentine curve from the central gate 110e to between the first source/drain 105a and the fourth source/drain 105d or along the boundary between the first quadrant area and the fourth quadrant area. A width of each of the first to fourth branch gates 110a, 110b, 110c, and 110d may be less than a width of the central gate 110e.

When the first to fourth branch gates 110a, 110b, 110c, and 110d have a serpentine curve shape, a surface area of each of the first to fourth branch gates 110a, 110b, 110c, and 110d may be greater when compared to a case in which the first to fourth branch gates 110a, 110b, 110c, and 110d have a straight line shape. Accordingly, current injection efficiency may be improved, and thus, operating characteristics of the semiconductor device 100 may be improved. Also, even when the semiconductor device 100 is manufactured in a small size with a side length of 100 µm or less, the operating characteristics of the semiconductor device 100 may not deteriorate.

Referring to FIGS. 1 and 2C, an end of each of the first to fourth branch gates 110a, 110b, 110c, and 110d of the gate 110 may protrude further laterally than sidewalls of the gate insulating layer 106, the barrier layer 104, and the channel layer 103. For example, as shown in FIG. 2C, an end of the second branch gate 110b may extend along the surface of the gate insulating layer 106 to face the sidewall of the barrier layer 104 and the sidewall of the channel layer 103. In the cross-sectional view of FIG. 2C, only the end of the second branch gate 110b may be seen, but like the second branch gate 110b, ends of the first, third, and fourth branch gates 110a, 110c, and 110d may also extend along the surface of the gate insulating layer 106 to face the sidewall of the barrier layer 104 and the sidewall of the channel layer 103. Because the gate 110 including the first to fourth branch gates 110a, 110b, 110c, and 110d extends to the sidewall of the barrier layer 104 and the sidewall of the channel layer 103 without directly contacting the barrier layer 104, on/off control performance of the semiconductor device 100 due to the gate 110 may be further improved.

Also, the plurality of conductive layers 107a, 107b, 107c, and 107d including a conductive metal may be provided on the upper surface of the gate insulating layer 106. The plurality of conductive layers 107a, 107b, 107c, and 107d may be spaced apart from each other. When viewed from the top, the plurality of conductive layers 107a, 107b, 107c, and 107d may be arranged in areas near four vertices of the upper surface of the gate insulating layer 106, not to overlap the gate 110 including the central gate 110e and the first to fourth branch gates 110a, 110b, 110c, and 110d. For example, a first conductive layer 107a may be arranged in a vertex area of the first quadrant area on the upper surface of the gate insulating layer 106, a second conductive layer 107b may be arranged in a vertex area of the second quadrant area on the upper surface of the gate insulating layer 106, a third conductive layer 107c may be arranged in a vertex area of the third quadrant area on the upper surface of the gate insulating layer 106, and a fourth conductive layer 107d may be arranged in a vertex area of the fourth quadrant area on the upper surface of the gate insulating layer 106.

The first to fourth conductive layers 107a, 107b, 107c, and 107d may be electrically connected to corresponding sources/drains among the first to fourth sources/drains 105a, 105b, 105c, and 105d. For example, the first conductive layer 107a may be electrically connected to the first source/drain 105a, the second conductive layer 107b may be electrically connected to the second source/drain 105b, the third conductive layer 107c may be electrically connected to the third source/drain 105c, and the fourth conductive layer 107d may be electrically connected to the fourth source/drain 105d.

Referring to FIG. 2A, the fourth conductive layer 107d may extend to be in contact with a portion of the upper surface of the fourth source/drain 105d that are exposed and not covered by the gate insulating layer 106, and the third conductive layer 107c may extend to be in contact with a portion of the upper surface of the third source/drain 105c that are exposed and not covered by the gate insulating layer 106. Similarly, the first conductive layer 107a and the second conductive layer 107b may extend to be in contact with a portion of the first source/drain 105a and a portion of the second source/drain 105b, respectively. When viewed from the top, the first to fourth conductive layers 107a, 107b, 107c, and 107d may overlap corresponding sources/drains in areas in contact with the corresponding sources/drains among the first to fourth sources/drains 105a, 105b, 105c, and 105d, respectively.

The passivation layer 108 may include at least one oxide material among SiO₂, HfOₓ, and Al₂O₃, but is not limited thereto. The passivation layer 108 may be provided to cover the gate insulating layer 106, the gate 110, and the first to fourth conductive layers 107a, 107b, 107c, and 107d. Also, the passivation layer 108 may extend along the surface of the gate insulating layer 106 to cover a portion of the sidewall of the barrier layer 104, the sidewall of the channel layer 103, and the sidewall of the buffer layer 102.

The plurality of source/drain electrodes 109a, 109b, 109c, and 109d and the gate electrode 111 may be provided to pass through the passivation layer 108 and be electrically connected to the first to fourth conductive layers 107a, 107b, 107c, and 107d and the gate 110 under the passivation layer 108, respectively. For example, a first source/drain electrode 109a may be provided to pass through the passivation layer 108 and be electrically connected to the first conductive layer 107a, a second source/drain electrode 109b may be provided to pass through the passivation layer 108 and be electrically connected to the second conductive layer 107b, a third source/drain electrode 109c may be provided to pass through the passivation layer 108 and be electrically connected to the third conductive layer 107c, and a fourth source/drain electrode 109d may be provided to pass through the passivation layer 108 and be electrically connected to the fourth conductive layer 107d. The first to fourth source/drain electrodes 109a, 109b, 109c, and 109d may be electrically connected to corresponding sources/drains among the first to fourth sources/drains 105a, 105b, 105c, and 105d through the first to fourth conductive layers 107a, 107b, 107c, and 107d, respectively. In other words, the first source/drain electrode 109a may be electrically connected to the first source/drain 105a through the first conductive layer 107a, the second source/drain electrode 109b may be electrically connected to the second source/drain 105b through the second conductive layer 107b, the third source/drain electrode 109c may be electrically connected to the third source/drain 105c through the third conductive layer 107c, and the fourth source/drain electrode 109d may be electrically connected to the fourth source/drain 105d through the fourth conductive layer 107d. Also, the gate electrode 111 may be provided to pass through the passivation layer 108 and be electrically connected to the gate 110.

The semiconductor device 100 having the aforementioned structure may be manufactured in a small size having a side length of 100 µm or less. The semiconductor device 100 having such a small size may be transferred in large quantities to another semiconductor substrate or heat dissipation substrate having a large area through FSA transfer. To this end, the semiconductor device 100 may have a symmetrical electrode arrangement structure suitable for FSA transfer.

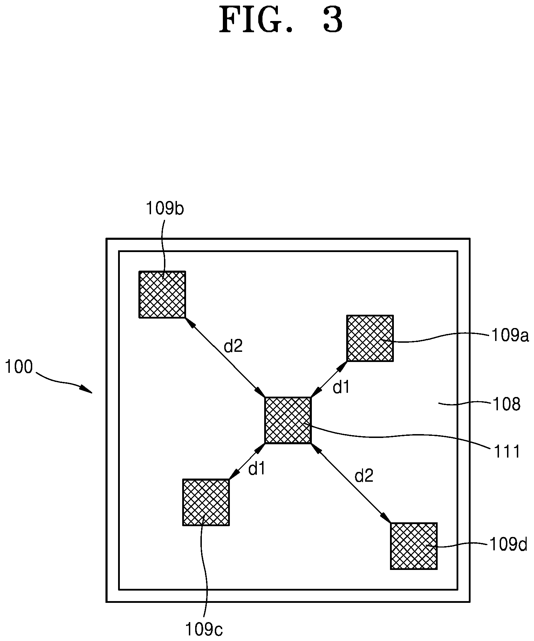

FIG. 3 is a schematic plan view of an electrode arrangement structure of the semiconductor device 100 shown in FIG. 1. Referring to FIG. 3, when viewed from the top, the gate electrode 111 may be arranged at a central area of the semiconductor device 100 or a central area of the passivation layer 108. Also, when viewed from the top, two source/drain electrodes diagonally facing each other among the first to fourth source/drain electrodes 109a, 109b, 109c, and 109d may be arranged at the same distance from the center of the semiconductor device 100, the center of the passivation layer 108, or the center of the gate electrode 111. For example, the first source/drain electrode 109a and the third source/drain electrode 109c facing each other in a first diagonal direction may be arranged at a first distance d1 from the center of the semiconductor device 100, the center of the passivation layer 108, or the center of the gate electrode 111, and the second source/drain electrode 109b and the fourth source/drain electrode 109d facing each other in a second diagonal direction crossing the first diagonal direction may be arranged at a second distance d2 from the center of the semiconductor device 100, the center of the passivation layer 108, or the center of the gate electrode 111.

In addition, source/drain electrodes that do not diagonally face each other among the first to fourth source/drain electrodes 109a, 109b, 109c, and 109d may be arranged at different distances from the center of the semiconductor device 100, the center of the passivation layer 108, or the center of the gate electrode 111. For example, the first distance d1 from the center of the semiconductor device 100, the center of the passivation layer 108, or the center of the gate electrode 111 to the first source/drain electrode 109a or the third source/drain electrode 109c may be different from the second distance d2 from the center of the semiconductor device 100, the center of the passivation layer 108, or the center of the gate electrode 111 to the second source/drain electrode 109b or the fourth source/drain electrode 109d. In this regard, it may be seen that, when viewed from the top, the first to fourth source/drain electrodes 109a, 109b, 109c, and 109d and the gate electrode 111 have a symmetrical arrangement structure in a diagonal direction with respect to the center of the semiconductor device 100, the center of the passivation layer 108, or the center of the gate electrode 111.

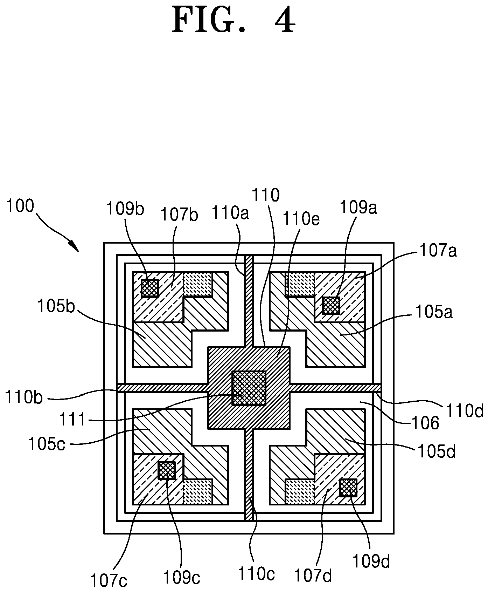

FIG. 4 is a plan view illustrating an example of a shape of the gate 110 in the semiconductor device 100, according to another embodiment. In FIG. 1, it has been shown that the first to fourth branch gates 110a, 110b, 110c, and 110d of the gate 110 extend in a serpentine curve from the central gate 110e, but the shape of the first to fourth branch gates 110a, 110b, 110c, and 110d is not limited thereto. Referring to FIG. 4, in another embodiment, the first to fourth branch gates 110a, 110b, 110c, and 110d may extend in a straight line.

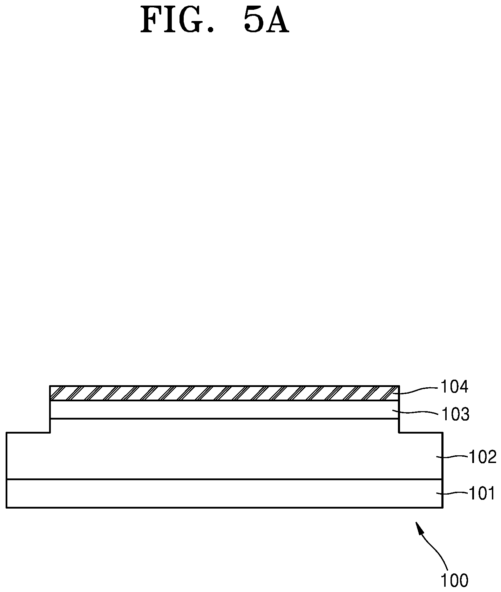

FIGS. 5A to 5L are views illustrating an example of a process of manufacturing the semiconductor device 100 shown in FIG. 1.

Referring to FIG. 5A, the buffer layer 102, the channel layer 103, and the barrier layer 104 may be sequentially grown on an upper surface of the substrate 101. The substrate 101 may include at least one of sapphire and Si, but is not limited thereto. The buffer layer 102 may include, for example, at least one of AlN, GaN, AlGaN, InGaN, AlInN, and AlGaInN, and the channel layer 103 may include, for example, at least one material among GaN, AlN, InN, InGaN, AlGaN, AlInN, and AlInGaN. The barrier layer 104 may include at least one material having a greater energy band gap than that of the channel layer 103 among GaN, InN, AlGaN, AlInN, InGaN, AlN, and AlInGaN. Although FIG. 5A shows a process of manufacturing a single semiconductor device 100 for convenience of description, a plurality of semiconductor devices 100 may be actually manufactured at once on a large-area substrate 101. After the barrier layer 104 is grown, a mesa structure may be formed by partially etching the barrier layer 104 and the channel layer 103 to be isolated from an area where other adjacent semiconductor devices are to be formed. The barrier layer 104 and the channel layer 103 remaining after the etching may be completely separated from the barrier layer 104 and the channel layer 103 in the area where other adjacent semiconductor devices are to be formed. During an etching process, an upper surface of the buffer layer 102 may also be partially removed, and a portion of the upper surface of the buffer layer 102 may be exposed to the outside along the edge.

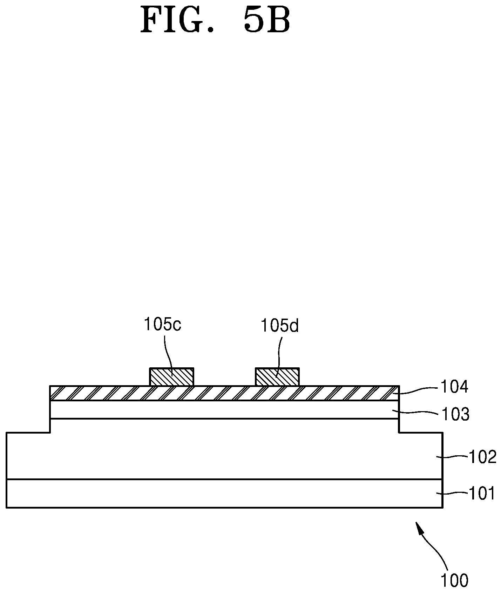

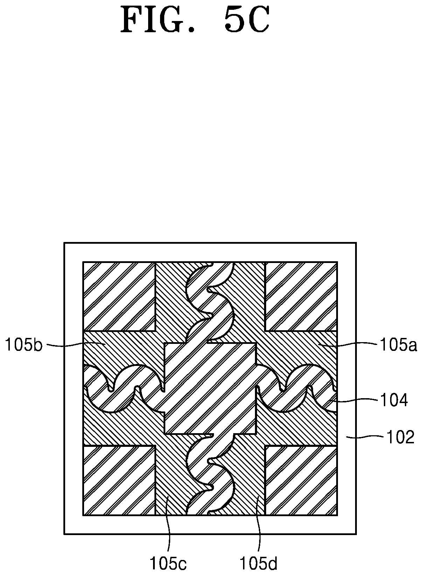

Referring to FIGS. 5B and 5C, the first to fourth sources/drains 105a, 105b, 105c, and 105d, which may be spaced apart from each other, may be formed on the upper surface of the barrier layer 104. As shown in FIG. 5C, the first to fourth sources/drains 105a, 105b, 105c, and 105d may be arranged in the first quadrant area, the second quadrant area, the third quadrant area, and the fourth quadrant area on the upper surface of the barrier layer 104, respectively. Also, the first to fourth sources/drains 105a, 105b, 105c, and 105d may be arranged avoiding the central area on the upper surface of the barrier layer 104, the areas near four vertices, and the area between two adjacent quadrant areas. For example, the first to fourth sources/drains 105a, 105b, 105c, and 105d may be formed by depositing a conductive metal to completely cover the barrier layer 104 and then patterning the conductive metal in the form shown in FIG. 5C.

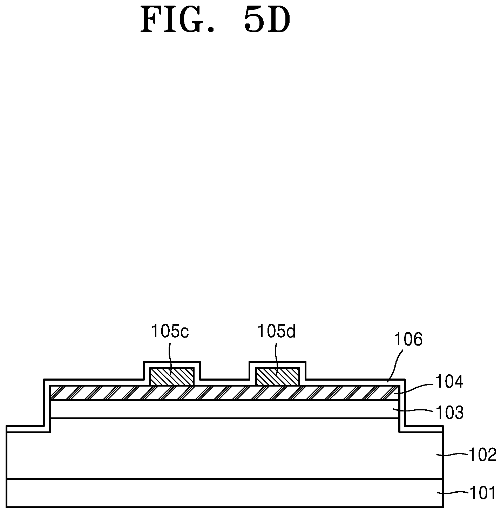

Referring to FIG. 5D, the gate insulating layer 106 may be formed to cover the barrier layer 104 and the first to fourth sources/drains 105a, 105b, 105c, and 105d. For example, the gate insulating layer 106 may be formed by depositing at least one oxide material among SiO₂, HfOₓ, and Al₂O₃ to a uniform thickness. The gate insulating layer 106 may be formed to cover the sidewall of the barrier layer 104, the sidewall of the channel layer 103, and an exposed upper surface of the buffer layer 102.

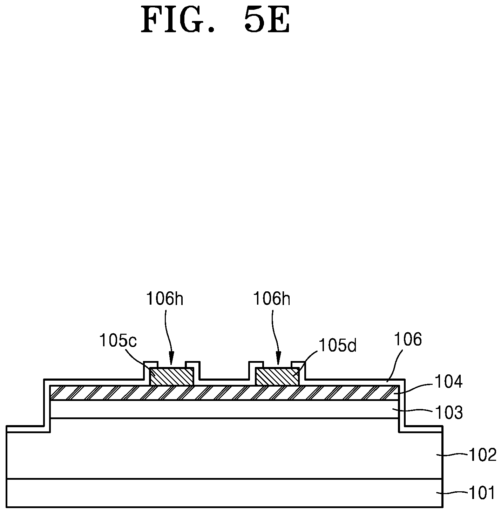

Referring to FIG. 5E, a plurality of openings 106h passing through the gate insulating layer 106 may be formed by etching a portion of the gate insulating layer 106 covering the first to fourth sources/drains 105a, 105b, 105c, and 105d. A portion of the upper surface of each of the first to fourth sources/drains 105a, 105b, 105c, and 105d may be exposed to the outside through the plurality of openings 106h of the gate insulating layer 106. Although only the third and fourth sources/drains 105c and 105d are shown in FIG. 5E, the openings 106h may also be formed on the upper surfaces of the first and second sources/drains 105a and 105b, respectively.

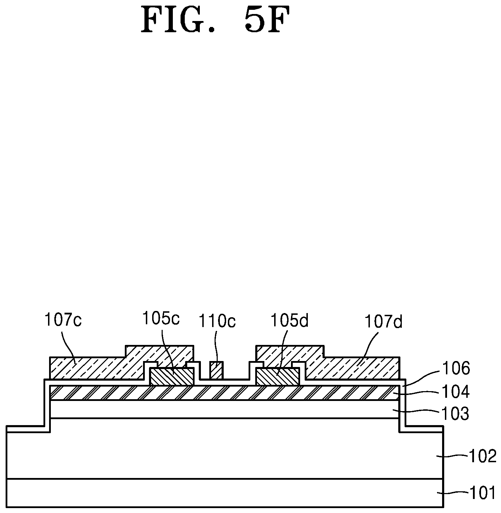

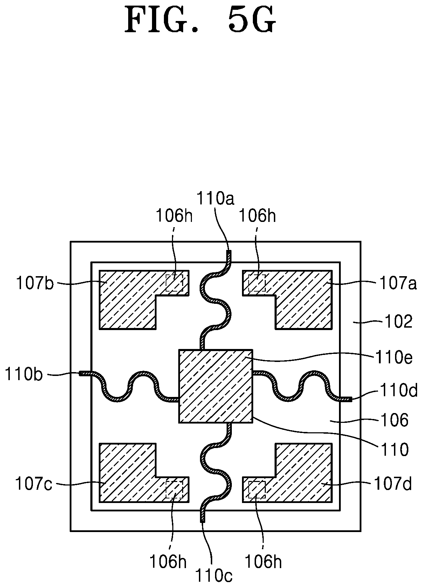

Referring to FIGS. 5F and 5G, the first to fourth conductive layers 107a, 107b, 107c, and 107d, which may be spaced apart from each other, and the gate 110 may be simultaneously formed on the upper surface of the gate insulating layer 106. As shown in FIG. 5G, the first to fourth conductive layers 107a, 107b, 107c, and 107d may be respectively arranged in a vertex area of the first quadrant area, a vertex area of the second quadrant area, a vertex area of the third quadrant area, and a vertex area of the fourth quadrant area, on the upper surface of the gate insulating layer 106. A portion of each of the first to fourth conductive layers 107a, 107b, 107c, and 107d may extend over an opening 106h of the gate insulating layer 106 to be electrically connected to a corresponding source/drain among the first to fourth sources/drains 105a, 105b, 105c, and 105d. Accordingly, the first to fourth conductive layers 107a, 107b, 107c, and 107d may be in contact with corresponding sources/drains among the first to fourth sources/drains 105a, 105b, 105c, and 105d through the openings 106h.

The gate 110 may be formed to have the central gate 110e and the first to fourth branch gates 110a, 110b, 110c, and 110d extending from the central gate 110e. The central gate 110e may be formed in a central portion of the upper surface of the gate insulating layer 106, and the first to fourth branch gates 110a, 110b, 110c, and 110d may be formed to extend between two adjacent sources/drains among the first to fourth sources/drains 105a, 105b, 105c, and 105d. When viewed from the top, the central gate 110e and the first to fourth branch gates 110a, 110b, 110c, and 110d may be formed not to overlap the first to fourth conductive layers 107a, 107b, 107c, and 107d.

For example, the first to fourth conductive layers 107a, 107b, 107c, and 107d, the central gate 110e, and the first to fourth branch gates 110a, 110b, 110c, and 110d may be formed by depositing a conductive metal to completely cover the gate insulating layer 106 and then patterning the conductive metal in the form as shown in FIG. 5G. Accordingly, the first to fourth conductive layers 107a, 107b, 107c, and 107d and the gate 110 may be simultaneously formed with the same conductive metal material.

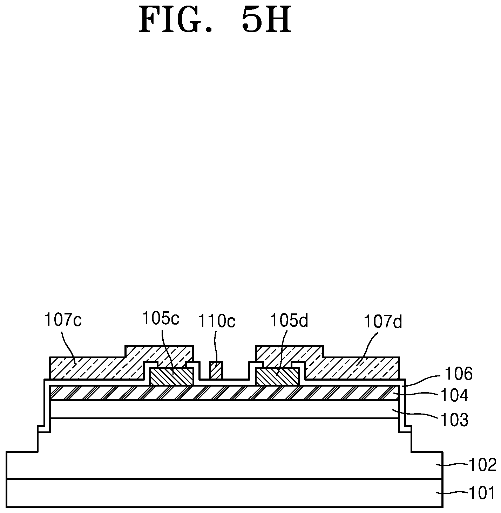

Referring to FIG. 5H, a portion of the edge of the buffer layer 102 may be further etched to be further isolated from the area where other adjacent semiconductor devices are to be formed. During this process, the edge of the gate insulating layer 106 may also be partially etched. Then, an edge area of the buffer layer 102 may have a stepped shape. An outermost edge area of the buffer layer 102 may not be covered by the gate insulating layer 106, and an inner edge area of the outermost edge may be covered by the gate insulating layer 106.

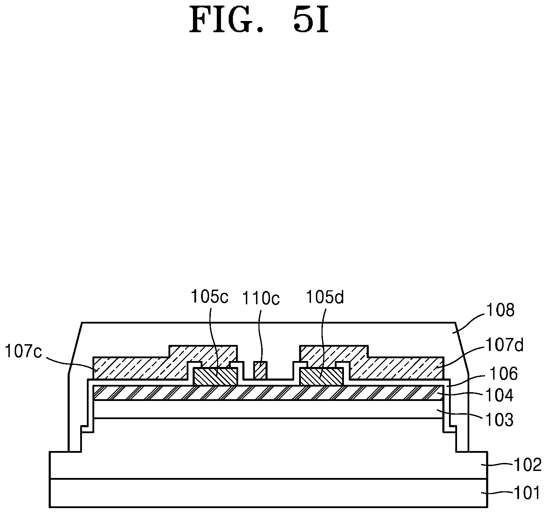

Referring to FIG. 5I, the passivation layer 108 may be formed to cover the gate insulating layer 106, the gate 110, and the first to fourth conductive layers 107a, 107b, 107c, and 107d. The passivation layer 108 may be formed by depositing, for example, at least one oxide material among SiO₂, HfOₓ, and Al₂O₃. The passivation layer 108 may be formed along the surface of the gate insulating layer 106 to cover the sidewall of the barrier layer 104, the sidewall of the channel layer 103, and the edge area of the buffer layer 102.

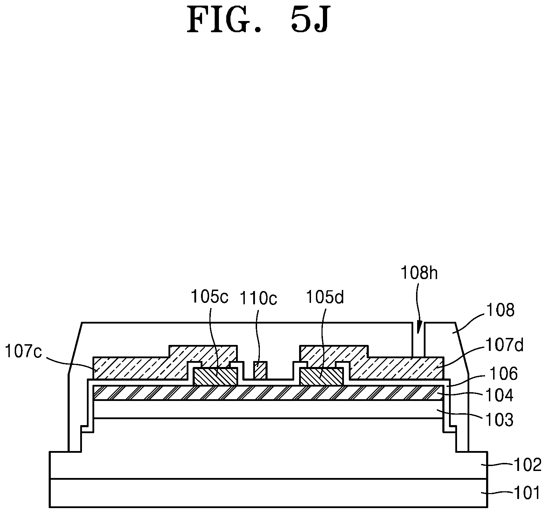

Referring to FIG. 5J, an opening 108h completely passing through the passivation layer 108 may be formed by etching a portion of the passivation layer 108 covering the first to fourth conductive layers 107a, 107b, 107c, and 107d. A portion of upper surfaces of the first to fourth conductive layers 107a, 107b, 107c, and 107d may be exposed to the outside through the opening 108h of the passivation layer 108. Although only one opening 108h that exposes the fourth conductive layer 107d is shown in FIG. 5J, openings 108h may also be formed on the upper surfaces of the first to third conductive layers 107a, 107b, and 107c. Positions of the openings 108h may be the same as the positions of the first to fourth source/drain electrodes 109a, 109b, 109c, and 109d described with reference to FIG. 3.

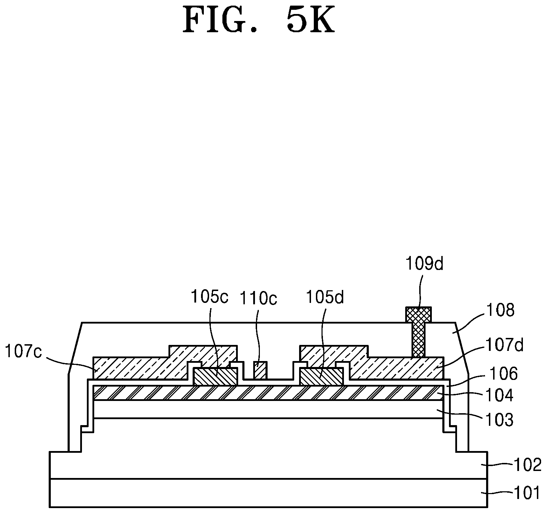

Referring to FIG. 5K, the first to fourth source/drain electrodes 109a, 109b, 109c, and 109d may be formed by filling the openings 108h of the passivation layer 108 with a conductive metal. Although only the fourth source/drain electrode 109d is shown in FIG. 5K, the first to third source/drain electrodes 109a, 109b, and 109c may be simultaneously formed to fill the openings 108h of the passivation layer 108. A portion of the first to fourth source/drain electrodes 109a, 109b, 109c, and 109d may also protrude over an upper surface of the passivation layer 108 and extend laterally along the upper surface of the passivation layer 108.

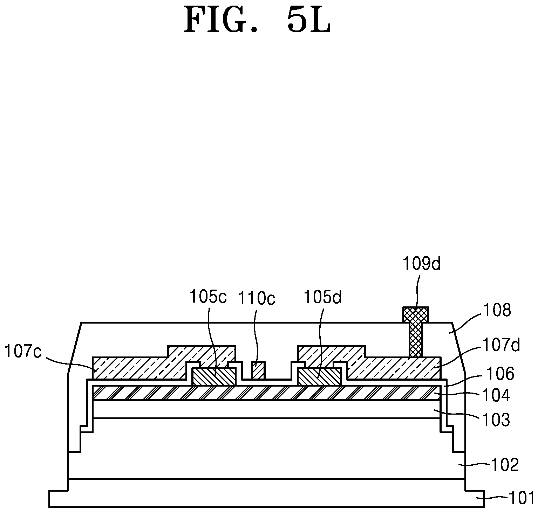

Referring to FIG. 5L, the plurality of semiconductor devices 100 may be separated from each other by further etching the substrate 101.

The semiconductor device 100 may be used, for example, as a power amplification element or switch in a high-power RF system including a radar system and a communication system, and various other electronic apparatuses. As described above, the semiconductor device 100 may be a group III-V semiconductor device including a group III-V semiconductor material. In addition, an electronic apparatus to which the semiconductor device 100 is to be applied may be manufactured on a group IV semiconductor substrate such as Si. Because it may be difficult to directly grow both of a group III-V semiconductor device and a group IV semiconductor device on a group IV semiconductor substrate, the semiconductor device 100 may be transferred onto the group IV semiconductor substrate by using an FSA transfer method.

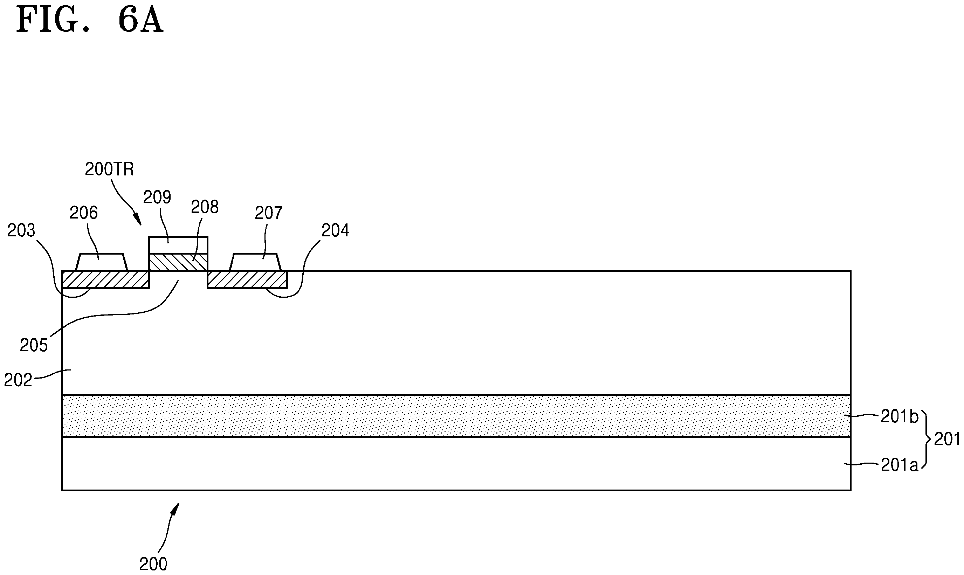

FIGS. 6A to 6F are views illustrating an example of a process of manufacturing an electronic apparatus by integrating the semiconductor device 100 shown in FIG. 1 on a heterogeneous semiconductor substrate.

Referring to FIG. 6A, an electronic apparatus 200 may include a first substrate 201, a second substrate 202 provided on an upper surface of the first substrate 201, and a first semiconductor device 200TR on the second substrate 202. The first substrate 201 may be a silicon-on-insulator (SOI) substrate including a semiconductor layer 201a and an insulating layer 201b provided on the upper surface of the semiconductor layer 201a. The second substrate 202 may include a first semiconductor material. For example, the first semiconductor material may include a group IV semiconductor material such as Si or germanium. The semiconductor layer 201a and the second substrate 202 may be, for example, a group IV semiconductor substrate including a group IV semiconductor material such as Si or germanium. The insulating layer 201b may include, for example, SiO₂ or silicon nitride (SiN). In FIG. 6A, it is shown that the electronic apparatus 200 may be formed over the SOI substrate, the electronic apparatus 200 may be manufactured by using a bulk silicon substrate instead of the SOI substrate. For example, the electronic apparatus 200 may include only the second substrate 202 without the first substrate 201.

The first semiconductor device 200TR may be a field effect transistor. For example, the first semiconductor device 200TR may include a source region 203 arranged on the second substrate 202, a drain region 204 arranged apart from the source region 203 on the second substrate 202, a channel layer 205 between the source region 203 and the drain region 204, a gate insulating layer 208 provided on an upper surface of the channel layer 205, a gate electrode 209 provided on an upper surface of the gate insulating layer 208, a source electrode 206 provided on an upper surface of the source region 203, and a drain electrode 207 provided on an upper surface of the drain region 204. The source region 203 and the drain region 204 may be formed by doping an upper portion of the second substrate 202. The first semiconductor device 200TR may be a group IV semiconductor device provided on a group IV semiconductor substrate and including a group IV semiconductor material.

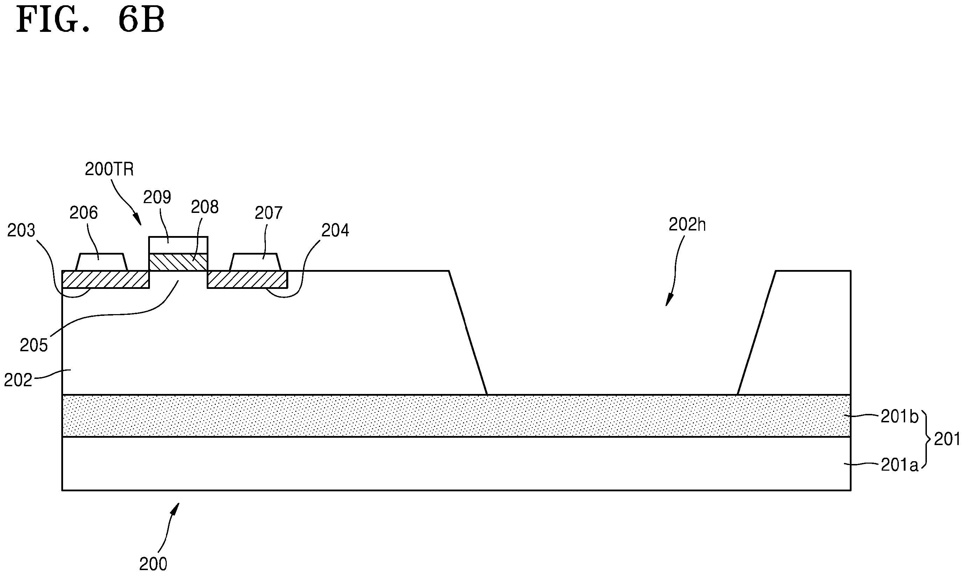

Referring to FIG. 6B, a groove 202h may be concavely formed by partially etching a portion of an upper surface of the second substrate 202 adjacent to the first semiconductor device 200TR. In this case, the insulating layer 201b of the first substrate 201 may function as an etch stop layer. An upper surface of the insulating layer 201b of the first substrate 201 may be partially etched through the groove 202h.

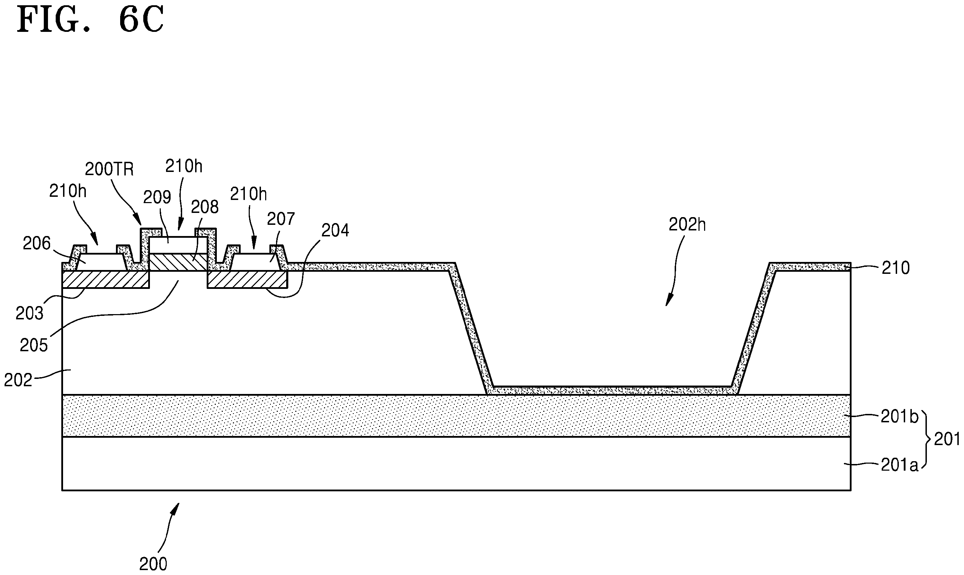

Referring to FIG. 6C, an insulating layer 210 may be formed to cover the first semiconductor device 200TR, the upper surface of the second substrate 202, and an inner wall and a bottom surface of the groove 202h. The insulating layer 210 may include an insulating material with hydrophilic properties. The insulating layer 210 may be formed by depositing, for example, at least one oxide material among SiO₂, HfOₓ, and Al₂O₃ to a uniform thickness. The inner wall of the groove 202h may be the inside of the second substrate 202 exposed by the groove 202h, and the bottom surface of the groove 202h may be the upper surface of the insulating layer 201b exposed by the groove 202h.

In addition, a portion of the insulating layer 210 may be etched such that upper surfaces of the source electrode 206, the drain electrode 207, and the gate electrode 209 of the first semiconductor device 200TR may be partially exposed. For example, a plurality of openings 210h completely passing through the insulating layer 210 may be formed by etching a portion of the insulating layer 210 covering the source electrode 206, the drain electrode 207, and the gate electrode 209.

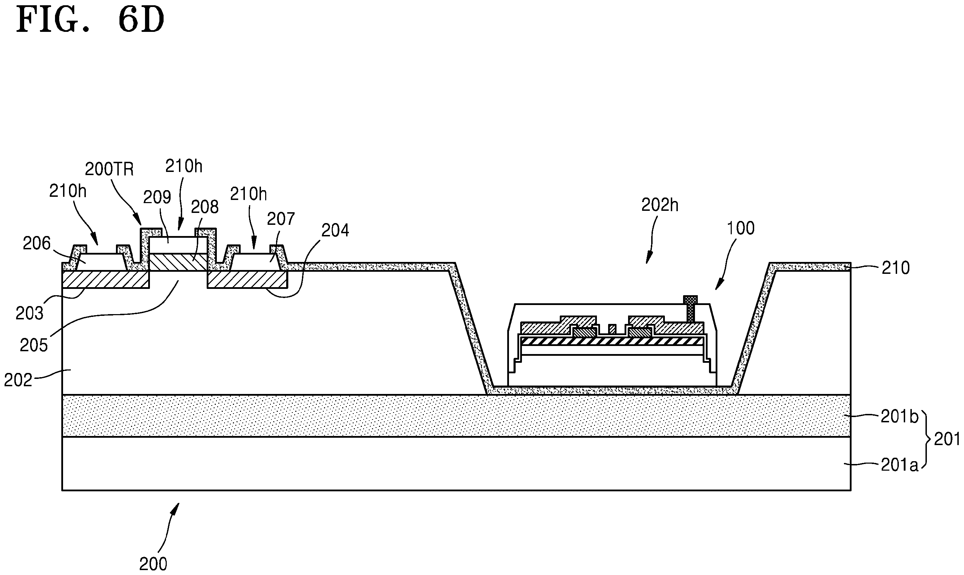

Referring to FIG. 6D, the semiconductor device 100 shown in FIG. 1 may be transferred into the groove 202h by using the FSA transfer method to be described below. Hereinafter, the semiconductor device 100 will be referred to as a second semiconductor device 100 to be identified from the first semiconductor device 200TR. The second semiconductor device 100 may include a second semiconductor material different from the first semiconductor material. For example, the second semiconductor material may include a group III-V semiconductor material such as AlN, GaN, AlGaN, InGaN, AlInN, and AlGaInN. Before FSA transfer, the substrate 101 may be removed in advance from the second semiconductor device 100 shown in FIG. 1 by using the chemical lift-off or laser lift-off method. Then, a lower surface of the second semiconductor device 100 becomes the lower surface of the buffer layer 102. The lower surface of the buffer layer 102 separated by using the chemical lift-off or laser lift-off method may have a very smooth and flat surface and may have hydrophilic properties. In contrast, an upper surface of the second semiconductor device 100 on which the gate electrode 111 and the first to fourth source/drain electrodes 109a, 109b, 109c, and 109d are formed may have hydrophobic properties. Accordingly, during an FSA transfer process, when the buffer layer 102 of the second semiconductor device 100 faces the bottom surface of the groove 202h, the second semiconductor device 100 may be easily disposed in the groove 202h. However, when the gate electrode 111 and the first to fourth source/drain electrodes 109a, 109b, 109c, and 109d face the bottom surface of the groove 202h, the second semiconductor device 100 may be easily separated from the groove 202h. Therefore, the second semiconductor device 100 may be transferred such that the gate electrode 111 and the first to fourth source/drain electrodes 109a, 109b, 109c, and 109d of the second semiconductor device 100 face the outside of the groove 202h.

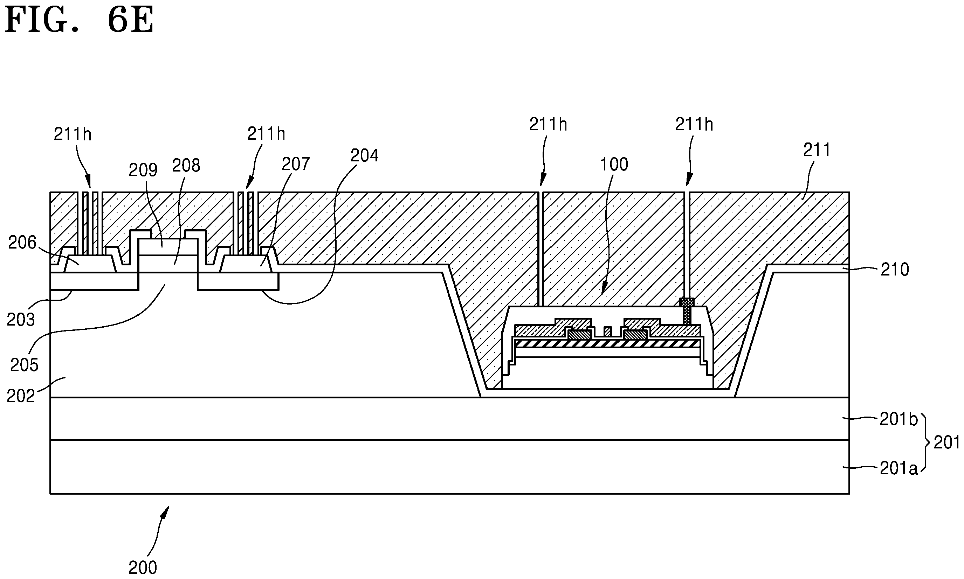

Referring to FIG. 6E, a passivation layer 211 may be formed to cover the first semiconductor device 200TR and the second semiconductor device 100. The passivation layer 211 may be formed to completely fill the inside of the groove 202h. Thereafter, a portion of the passivation layer 211 may be etched such that the upper surfaces of the source electrode 206, the drain electrode 207, and the gate electrode 209 of the first semiconductor device 200TR and upper surfaces of the gate electrode 111 and the first to fourth source/drain electrodes 109a, 109b, 109c, and 109d of the second semiconductor device 100 may be exposed. For example, a plurality of openings 211h completely passing through the passivation layer 211 may be formed by etching a portion of the passivation layer 211 covering the source electrode 206, the drain electrode 207, and the gate electrode 209 of the first semiconductor device 200TR and the gate electrode 111 and the first to fourth source/drain electrodes 109a, 109b, 109c, and 109d of the second semiconductor device 100. Although an opening 211h that exposes the gate electrode 209 of the first semiconductor device 200TR is not shown in FIG. 6E, the opening 211h that expose the gate electrode 209 of the first semiconductor device 200TR may be formed at a different position from a position in a cross section shown in FIG. 6E.

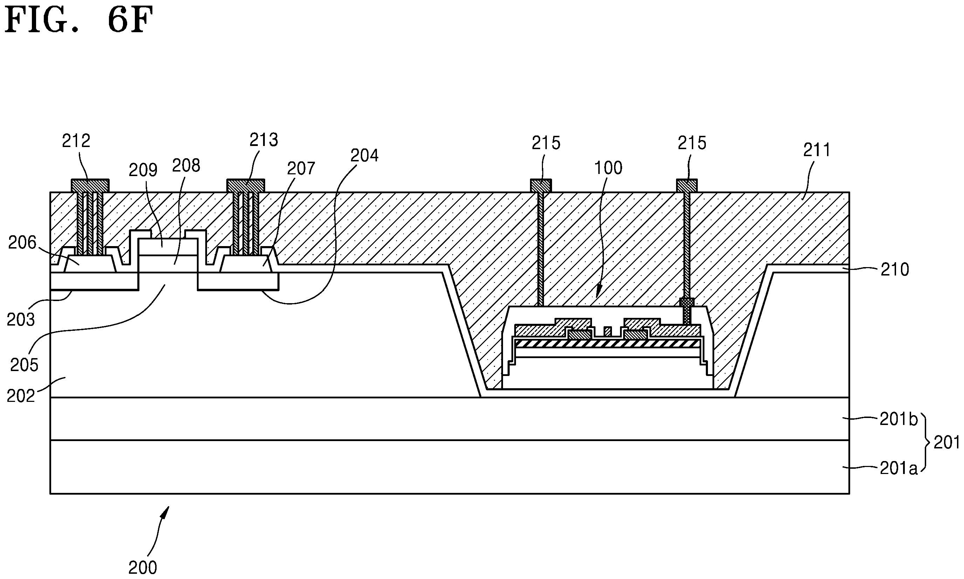

Referring to FIG. 6F, a plurality of electrode pads 212, 213, 215, and 216 may be formed by filling the plurality of openings 211h of the passivation layer 211 with a conductive metal. Although an electrode pad electrically connected to the gate electrode 209 of the first semiconductor device 200TR is not shown in FIG. 6F, the electrode pad electrically connected to the gate electrode 209 of the first semiconductor device 200TR may be formed at a different position from a position in a cross section shown in FIG. 6F. The plurality of electrode pads 212, 213, 215, and 216 may protrude over an upper surface of the passivation layer 211 and extend laterally along the upper surface of the passivation layer 211.

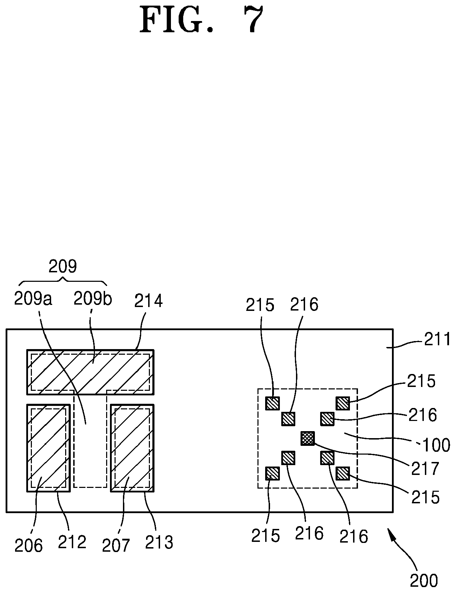

FIG. 7 is a plan view illustrating an example of an arrangement of a plurality of electrode pads included in the resulting electronic apparatus 200. Referring to FIG. 7, the electronic apparatus 200 may include a first electrode pad 212 electrically connected to the source electrode 206 of the first semiconductor device 200TR, a second electrode pad 213 electrically connected to the drain electrode 207, and a third electrode pad 214 electrically connected to the gate electrode 209. As indicated by a dotted line in the plan view of FIG. 7, the gate electrode 209 of the first semiconductor device 200TR may have a first portion 209a extending in a first direction between the source electrode 206 and the drain electrode 207 and a second portion 209b extending a second direction perpendicular to the first direction. Accordingly, the gate electrode 209 of the first semiconductor device 200TR may have a 'T' shape. The third electrode pad 214 may be arranged to be in contact with the second portion 209b of the gate electrode 209.

The electronic apparatus 200 may further include a plurality of fourth electrode pads 215 electrically connected to one of the first source/drain electrode 109a and the third source/drain electrode 109c of the second semiconductor device 100, a plurality of fifth electrode pads 216 electrically connected to one of the second source/drain electrode 109b and the fourth source/drain electrode 109d of the second semiconductor device 100, and a sixth electrode pad 217 electrically connected to the gate electrode 111 of the second semiconductor device 100. For example, four fourth electrode pads 215 may be positioned at the second distance d2 in a diagonal direction from the center of the sixth electrode pad 217, and four fifth electrode pads 216 may be positioned at the first distance d1 in a diagonal direction from the center of the sixth electrode pad 217. Accordingly, during the FSA transfer process, regardless of a rotation direction of the second semiconductor device 100, each of the first source/drain electrode 109a and the third source/drain electrode 109c of the second semiconductor device 100 may be electrically connected to any one of the four fourth electrode pads 215, and each of the second source/drain electrode 109b and the fourth source/drain electrode 109d may be electrically connected to any one of the four fifth electrode pads 216.

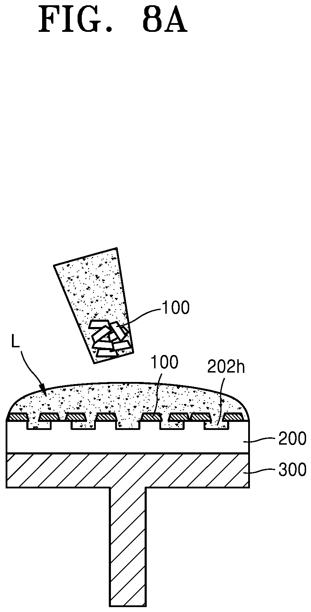

FIGS. 8A to 8C are views illustrating an example of a process of FSA transfer of the second semiconductor device 100 shown in FIG. 1 onto a heterogeneous semiconductor substrate.

Referring to FIG. 8A, the electronic apparatus 200 to which the second semiconductor device 100 is to be transferred may be mounted on a transfer head 300. The electronic apparatus 200 may include a plurality of grooves 202h in which the plurality of second semiconductor devices 100 may be respectively disposed. The plurality of second semiconductor devices 100 may be directly sprayed on the electronic apparatus 200 after a liquid L is supplied to the grooves 202h of the electronic apparatus 200, or the plurality of second semiconductor devices 100 may be included in the liquid L and supplied onto the electronic apparatus 200.

The liquid L supplied to the groove 202h may be any type of liquid as long as the liquid does not corrode or damage the second semiconductor device 100 and the electronic apparatus 200. The liquid L may be supplied to the groove 202h by using various methods, such as a spray method, a dispensing method, an inkjet dot method, or a method of flowing the liquid L into the electronic apparatus 200. The liquid L may include, for example, one or a plurality of combinations of a group including water, ethanol, alcohol, polyol, ketone, halocarbon, acetone, flux, and an organic solvent. The organic solvent may include, for example, isopropyl alcohol (IPA). A supply amount of the liquid L may be variously adjusted to fit into the groove 202h or to overflow from the groove 202h.

The plurality of second semiconductor devices 100 may be directly sprayed on the electronic apparatus 200 without any other liquid, or may be included in the liquid L such as a suspension and supplied onto the electronic apparatus 200. As a method of supplying the second semiconductor device 100 included in the suspension, various methods may be used, such as a spray method, a dispensing method of dropping a liquid in droplets, an inkjet dot method of ejecting a liquid like a printing method, or a method of flowing a suspension into the electronic apparatus 200.

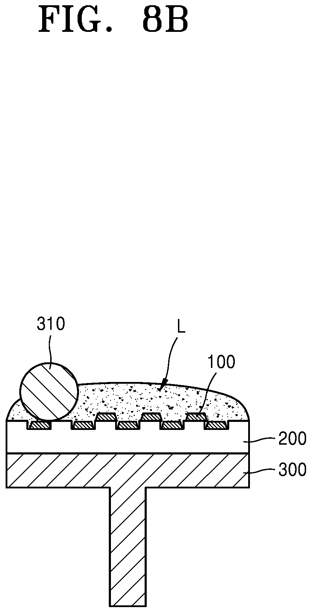

Referring to FIG. 8B, after the plurality of second semiconductor devices 100 are supplied onto the electronic apparatus 200, scanning may be performed to align the plurality of second semiconductor devices 100. For example, an absorber 310 may scan an upper surface of the electronic apparatus 200. According to the scanning, the absorber 310 contacts the electronic apparatus 200 and passes through the plurality of grooves 202h and thus may move the second semiconductor devices 100 into the grooves 202h and absorb the liquid L in the grooves 202h. The absorber 310 may be sufficient as long as the absorber is a material that may absorb the liquid L, and the shape and structure thereof is not limited. The absorber 310 may include, for example, a fabric, a tissue, polyester fiber, paper, or a wiper.

The absorber 310 may scan the electronic apparatus 200 while pressing the electronic apparatus 200 at an appropriate pressure. The scanning may be performed by various methods, such as a sliding method, a rotating method, a translating motion method, a reciprocating motion method, a rolling method, a spinning method, and/or a rubbing method of the absorber 310. The scanning may include both a regular method and an irregular method. The scanning may be performed by moving the transfer head 300 instead of moving the absorber 310. Also, the scanning may be performed through cooperation between the absorber 310 and the transfer head 300.

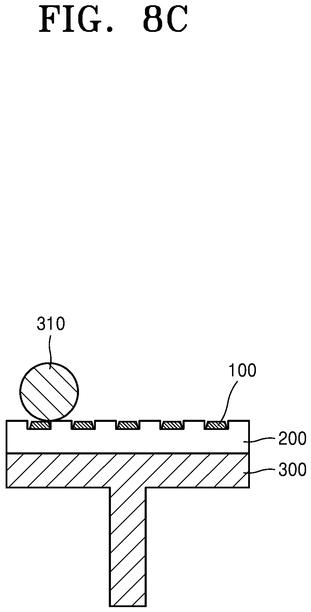

Referring to FIG. 8C, after the absorber 310 scans the electronic apparatus 200, the second semiconductor devices 100 that do not fill the grooves 202h and remain on the upper surface of the electronic apparatus 200 may be recovered. The processes described above may be repeated until the second semiconductor devices 100 are disposed in all the grooves 202h. As described above, a large number of second semiconductor devices 100 may be aligned in a large-area electronic apparatus 200 by using the FSA transfer method.

As described above, the lower surface of the buffer layer 102 of the second semiconductor device 100 may be very smooth and flat and may have hydrophilic properties. Also, the bottom surface of the groove 202h may be very smooth and flat and have hydrophilic properties. Accordingly, during the FSA transfer process shown in FIGS. 8A to 8C, when the buffer layer 102 of the second semiconductor device 100 faces the bottom surface of the groove 202h, the second semiconductor device 100 may be easily disposed and fixed in the groove 202h by a van der Waals force. In contrast, when the first to fourth source/drain electrodes 109a, 109b, 109c, and 109d face the bottom surface of the groove 202h, the second semiconductor device 100 may be easily separated from the groove 202h during a scanning process. When the scanning process is repeated, only the second semiconductor device 100 remains in the groove 202h with the buffer layer 102 facing the bottom surface of the groove 202h. The remaining second semiconductor devices 100 may be recovered while remaining on the upper surface of the electronic apparatus 200.

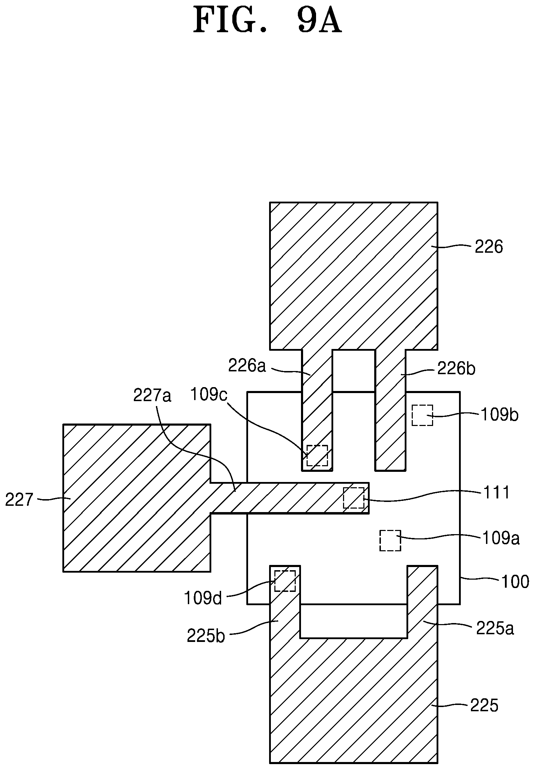

After the process shown in FIG. 6F, wires for electrical connection with the second semiconductor device 100 in the electronic apparatus 200 may be further formed. FIGS. 9A to 9C are views illustrating examples of various wiring patterns for electrical connection with the second semiconductor device 100 shown in FIG. 1 in the electronic apparatus 200, according to an embodiment. FIGS. 9A to 9C are schematic views of resulting connections between the first to fourth source/drain electrodes 109a, 109b, 109c, and 109d and the gate electrode 111 of the second semiconductor device 100 and wires. However, the wires shown in FIGS. 9A to 9C may actually be in direct contact with the fourth to sixth electrode pads 215, 216, and 217 shown in FIG. 7 and indirectly connected to the first to fourth source/drain electrodes 109a, 109b, 109c, and 109d and the gate electrode 111.

Referring to FIG. 9A, the electronic apparatus 200 may include a first wire 225, a second wire 226, and a third wire 227. The first to third wires 225, 226, and 227 may be electrically connected to the second semiconductor device 100 such that the second semiconductor device 100 normally operates regardless of a rotation direction of the second semiconductor device 100 during a transfer process. For example, the first wire 225 and the second wire 226 may be arranged on opposite sides of the second semiconductor device 100 to face each other. The first wire 225 may include two arms 225a and 225b extending in a straight line toward the second semiconductor device 100 to be connected to any one of the second source/drain electrode 109b and the fourth source/drain electrode 109d positioned at the second distance d2 from the center of the second semiconductor device 100. The second wire 226 may include two arms 226a and 226b extending in a straight line toward the second semiconductor device 100 to be connected to any one of the first source/drain electrode 109a and the third source/drain electrode 109c positioned at the first distance d1 from the center of the second semiconductor device 100. In this case, an interval between the two arms 225a and 225b of the first wire 225 may be greater than an interval between the two arms 226a and 226b of the second wire 226.

The third wire 227 may be arranged to face one of two sides of the second semiconductor device 100 that do not face the first wire 225 and the second wire 226. The third wire 227 may include one arm 227a extending in a straight line toward the center of the second semiconductor device 100 to be connected to the gate electrode 111. An extension direction of the arm 227a of the third wire 227 may be perpendicular to an extension direction of the arms 225a and 225b of the first wire 225 and an extension direction of the arms 226a and 226b of the second wire 226.

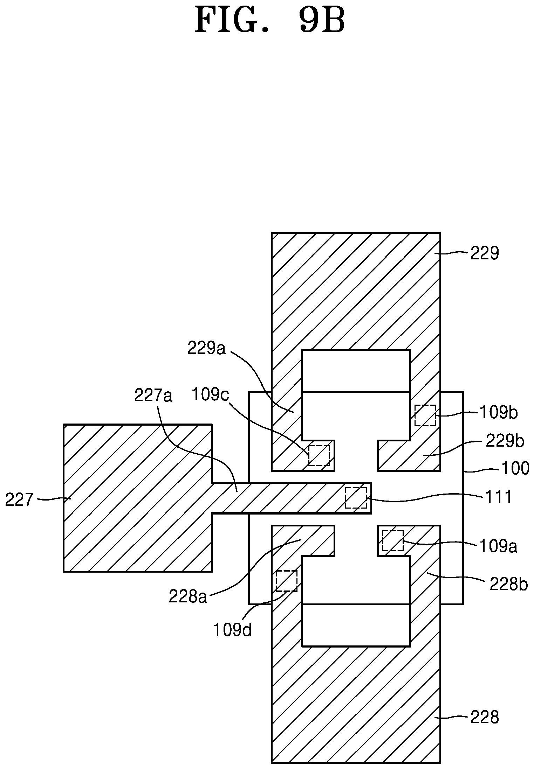

Referring to FIG. 9B, the electronic apparatus 200 may include a first wire 228, a second wire 229, and the third wire 227. The first wire 228 and the second wire 229 may be arranged on opposite sides of the second semiconductor device 100 to face each other and may have the same shape. The first wire 228 may include two arms 228a and 228b bent to be connected to any two adjacent source/drain electrodes among the first to fourth source/drain electrodes 109a, 109b, 109c, and 109d, and the second wire 229 may include two arms 229a and 229b bent to be connected to the other two source/drain electrodes, which may not be connected to the first wire 228 and may be adjacent to each other, among the first to fourth source/drain electrodes 109a, 109b, 109c, and 109d. For example, the two arms 228a and 228b of the first wire 228 and the two arms 229a and 229b of the second wire 229 may have a shape of being bent at 90 degrees to extend in a straight line toward the second semiconductor device 100 to be connected to any one of the second source/drain electrode 109b and the fourth source/drain electrode 109d positioned at the second distance d2 from the center of the second semiconductor device 100, and then to be connected to any one of the first source/drain electrode 109a and the third source/drain electrode 109c positioned at the first distance d1 from the center of the second semiconductor device 100.

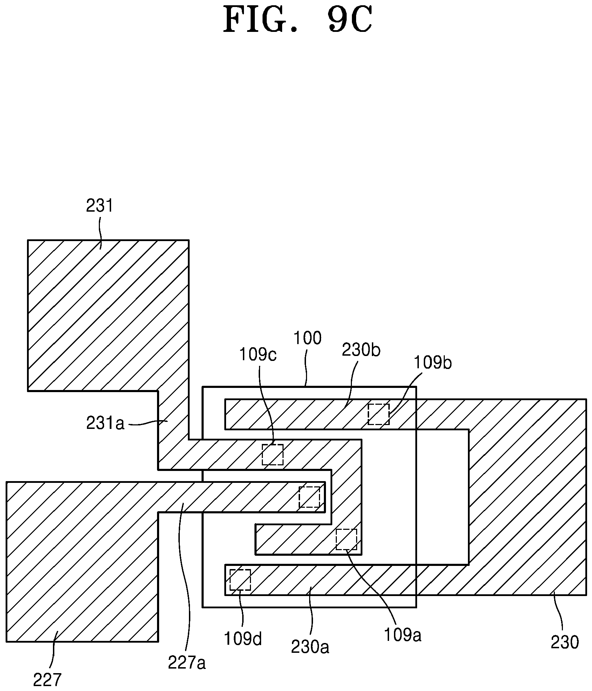

Referring to FIG. 9C, the electronic apparatus 200 may include a first wire 230, a second wire 231, and the third wire 227. The first wire 230 may include two arms 230a and 230b extending in a straight line toward the center of the second semiconductor device 100 to be connected to both the second source/drain electrode 109b and the fourth source/drain electrode 109d positioned at the second distance d2 from the center of the second semiconductor device 100. The second wire 231 may include one arm 231a bent to be connected to both the first source/drain electrode 109a and the third source/drain electrode 109c positioned at the first distance d1 from the center of the second semiconductor device 100. For example, the arm 231a of the second wire 231 may have a shape of being bent twice at 90 degrees each to surround three sides of the arm 227a of the third wire 227 between the two arms 230a and 230b of the first wire 230.

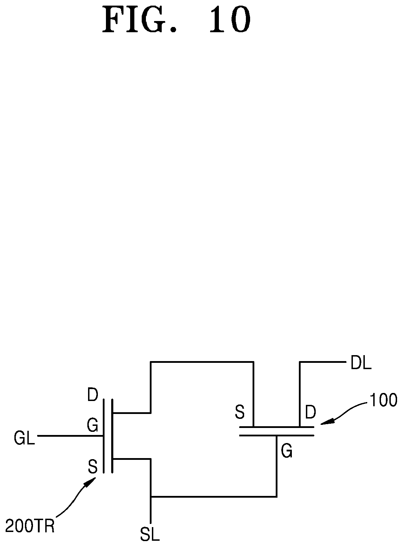

FIG. 10 is a circuit diagram illustrating an example of an equivalent circuit of the electronic apparatus 200, according to an embodiment. Referring to FIG. 10, the source electrode 206 of the first semiconductor device 200TR may be electrically connected to the gate electrode 111 of the second semiconductor device 100, and the drain electrode 207 of the first semiconductor device 200TR may be electrically connected to any two of the first to fourth source/drain electrodes 109a, 109b, 109c, and 109d of the second semiconductor device 100. Also, the gate electrode 209 of the first semiconductor device 200TR may be connected to a separate gate line GL, and the source electrode 206 of the first semiconductor device 200TR may be connected to a separate source line SL. The other two source/drain electrodes that are not connected to the drain electrode 207 of the first semiconductor device 200TR among the first to fourth source/drain electrodes 109a, 109b, 109c, and 109d of the second semiconductor device 100 may be connected to a separate drain line DL.

As described above, the second semiconductor device 100 may be an HEMT, and the HEMT may generally have normally-on characteristics. In other words, even though no voltage is applied to the gate electrode 111, a current flows through a channel between two adjacent sources/drains, and when a voltage is applied to the gate electrode 111, the second semiconductor device 100 may be turned off. When the first semiconductor device 200TR and the second semiconductor device 100 are connected as shown in FIG. 10, the electronic apparatus 200 may have normally-off characteristics. In this case, when a voltage higher than or equal to a threshold voltage is applied through the gate line GL, a current may flow between the source line SL and the drain line DL. Accordingly, the electronic apparatus 200 may be used as, for example, a cascode HEMT.

The equivalent circuit of the electronic apparatus 200 shown in FIG. 10 is merely one example of various electronic apparatus that may be formed by combining a group III-V semiconductor device and a group IV semiconductor device on one substrate. Also, the electronic apparatus 200 may further include circuits or devices that perform additional functions in addition to the cascode HEMT shown in FIG. 10. For example, the electronic apparatus 200 may be a radar system or a communication system including a plurality of cascode HEMTs.

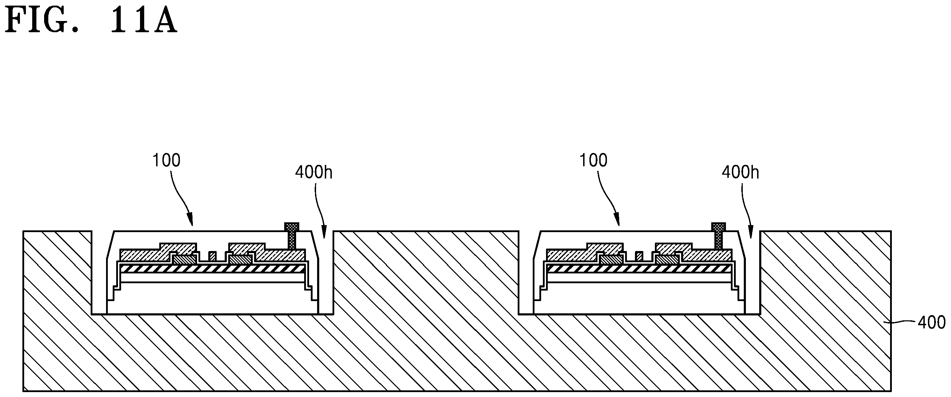

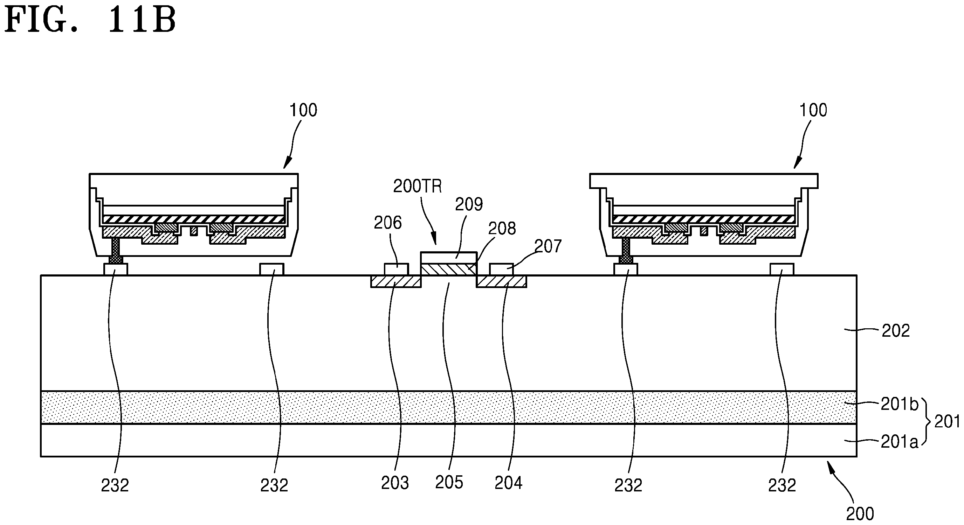

In FIGS. 6A to 6F, it has been described that the groove 202h may be formed in the second substrate 202 of the electronic apparatus 200, and the second semiconductor device 100 shown in FIG. 1 may be directly transferred to the electronic apparatus 200. However, after the second semiconductor device 100 is first aligned on a separate transfer substrate, the second semiconductor device 100 may be transferred to the electronic apparatus 200 by using the transfer substrate. FIGS. 11A and 11B are views illustrating an example of a process of manufacturing an electronic apparatus by transferring the second semiconductor device 100 shown in FIG. 1 onto a heterogeneous semiconductor substrate through a separate transfer substrate.

Referring to FIG. 11A, a transfer substrate 400 including a plurality of grooves 400h may be mounted on the transfer head 300 shown in FIGS. 8A to 8C. Thereafter, similar to the FSA transfer process described with reference to FIGS. 8A to 8C, the second semiconductor devices 100 may be aligned in the plurality of grooves 400h of the transfer substrate 400. In this case, the second semiconductor device 100 may be aligned in a groove 400h such that the gate electrode 111 and the first to fourth source/drain electrodes 109a, 109b, 109c, and 109d of the second semiconductor device 100 face the outside of the groove 400h.

Referring to FIG. 11B, the second semiconductor device 100 may be transferred onto the upper surface of the second substrate 202 of the electronic apparatus 200 on which the first semiconductor device 200TR is formed. For example, the transfer substrate 400 may be arranged on the electronic apparatus 200 such that the gate electrode 111 and the first to fourth source/drain electrodes 109a, 109b, 109c, and 109d of the second semiconductor device 100 face the upper surface of the second substrate 202. Thereafter, the transfer substrate 400 may be separated from the electronic apparatus 200 with the second semiconductor device 100 remaining.

In this case, no groove may be formed in the second substrate 202 of the electronic apparatus 200, and accordingly, the second substrate 202 may have a flat upper surface. A plurality of electrode pads 232 may be formed in advance on the upper surface of the second substrate 202. The second semiconductor device 100 may be fixed and electrically connected to the plurality of electrode pads 232 through, for example, solder bumping. In a cross-sectional view of FIG. 11B, it is shown that the second semiconductor device 100 may be fixed to only one electrode pad 232. However, a plurality of electrode pads may be further arranged on a different cross section from the cross section of FIG. 11B, and one second semiconductor device 100 may be fixed by the plurality of electrode pads.

So far, an example has been described where the first semiconductor device 200TR including the first semiconductor material is a field-effect transistor and the electronic apparatus 200 is a cascode HEMT, but the first semiconductor device 200TR and the electronic apparatus 200 are not necessarily limited thereto. For example, a first semiconductor device including a first semiconductor material may be a light-emitting device or various sensor devices in addition to the field-effect transistor. Also, the electronic apparatus 200 may be implemented as a radar system, a LiDAR system, or a communication system including an HEMT together with a light-emitting device or various sensor devices.

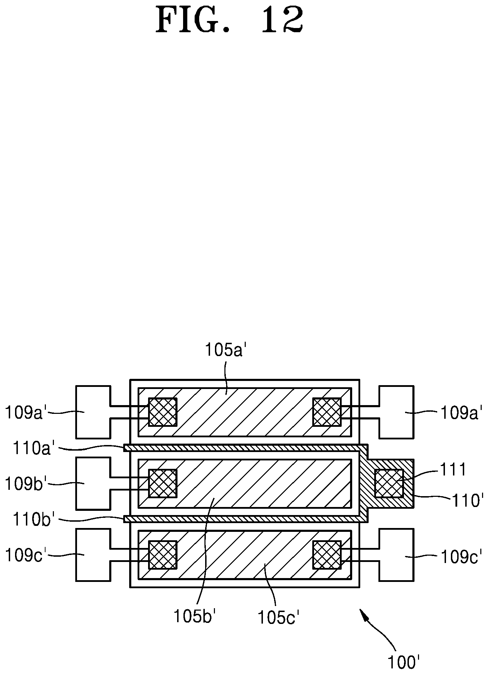

Moreover, it has been described that the semiconductor device 100 shown in FIG. 1 may have a square shape when viewed from the top. Also, it has been described that the semiconductor device 100 may include four source/drain electrodes. However, the semiconductor device may have a rectangular shape or may have three source/drain electrodes. FIG. 12 is a plan view illustrating an example of an electrode arrangement of a semiconductor device, according to another embodiment.

Referring to FIG. 12, a semiconductor device 100' may include first, second, and third sources/drains 105a', 105b', and 105c' extending in a first direction. The first to third sources/drains 105a', 105b', and 105c' may be sequentially arranged in a second direction perpendicular to the first direction. Accordingly, the second source/drain 105b' may be between the first source/drain 105a' and the third source/drain 105c' in the second direction. Also, a gate 110' of the semiconductor device 100' may include a first branch gate 110a' extending in the first direction between the first source/drain 105a' and the second source/drain 105b' and a second branch gate 110b' extending in the first direction between the second source/drain 105b' and the third source/drain 105c'. In FIG. 12, it is shown that the first to third sources/drains 105a', 105b', and 105c' and the gate 110' may be on the same plane for convenience of description. However, as already described with reference to FIGS. 2A to 2C, the first to third sources/drains 105a', 105b', and 105c' may be arranged on the barrier layer 104, and the gate 110' may be arranged on the gate insulating layer 106.

Over the passivation layer 108 described with reference to FIGS. 2A to 2C, two first source/drain electrodes 109a' may be arranged on both sides of the first source/drain 105a' and may be electrically connected to the first source/drain 105a' through the passivation layer 108. One second source/drain electrode 109b' may be arranged on one side of the second source/drain 105b' over the passivation layer 108 and may be electrically connected to the second source/drain 105b' through the passivation layer 108. Also, two third source/drain electrodes 109c' may be arranged on both sides of the third source/drain 105c' over the passivation layer 108 and may be electrically connected to the third source/drain 105c' through the passivation layer 108. Also, one gate electrode 111 may be arranged on one side of the gate 110' over the passivation layer 108 and may be electrically connected to the gate 110' through the passivation layer 108. The gate electrode 111 and the second source/drain electrode 109b' may be arranged on opposite sides of the semiconductor device 100' in the first direction to face each other.

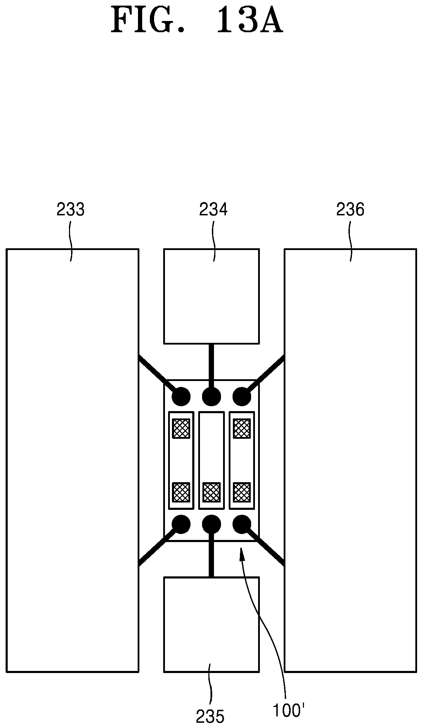

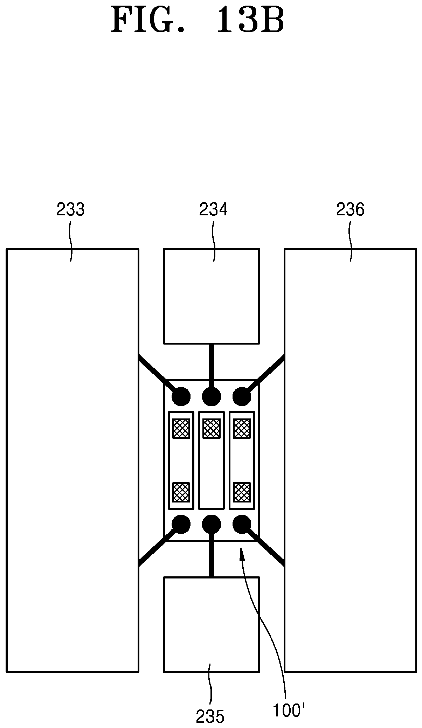

FIGS. 13A and 13B are views illustrating an example of wiring patterns for electrical connection with the semiconductor device 100' in the electronic apparatus 200 including the semiconductor device 100' shown in FIG. 12. Referring to FIGS. 13A and 13B, the electronic apparatus 200 may include first, second, third, and fourth wires 233, 234, 235, and 236. The first wire 233 and the fourth wire 236 may be arranged to face two long sides of the semiconductor device 100', and the second wire 234 and the third wire 235 may be arranged to face two short sides of the semiconductor device 100'.

When the semiconductor device 100' is transferred onto the electronic apparatus 200 by using the FSA transfer method, the semiconductor device 100' may be arranged in two different directions. For example, as shown in FIG. 13A, the gate electrode 111 may be positioned at the top and the second source/drain electrode 109b' may be positioned at the bottom in the drawing, or as shown in FIG. 13B, the second source/drain electrode 109b' may be positioned at the top and the gate electrode 111 may be positioned at the bottom. In the case of FIG. 13A, the first wire 233 may be connected to the first source/drain electrodes 109a', and the fourth wire 236 may be connected to a third source/drain electrode 109c'. Also, the second wire 234 may be connected to the gate electrode 111, and the third wire 235 may be connected to the second source/drain electrode 109b'. In the case of FIG. 13B, the first wire 233 may be connected to the third source/drain electrode 109c', and the fourth wire 236 may be connected to the first source/drain electrodes 109a'. Also, the second wire 234 may be connected to the second source/drain electrode 109b', and the third wire 235 may be connected to the gate electrode 111.

In this case, the first source/drain 105a' and the third source/drain 105c' may function as sources shown in FIG. 10. According to the semiconductor device 100' shown in FIG. 13A or 13B, the second wire 234 may be connected to a gate line and the third wire 235 may be connected to a drain line, or the second wire 234 may be connected to a drain line and the third wire 235 may be connected to a gate line.

The aforementioned semiconductor devices and the electronic apparatuses including the same have been described with reference to the embodiments shown in the drawings, but these are merely examples, and it should be understood that various modifications and other equivalent embodiments may be made by those of ordinary skill in the art. Therefore, the disclosed embodiments should be considered from an illustrative sense than a restrictive sense. The scope of the disclosure is indicated in the claims, not the foregoing description, and all differences within the equivalent scope should be interpreted as being included in the scope of disclosure.

It should be understood that the embodiments described herein should be considered in a descriptive sense only and not for purposes of limitation. Descriptions of features or aspects within each of the embodiments should typically be considered as available for other similar features or aspects in other embodiments. While one or more embodiments have been described with reference to the figures, it will be understood by one of ordinary skill in the art that various changes in form and details may be made therein without departing from the scope as defined by the following claims.

## Claims

1. A semiconductor device comprising:
a channel layer comprising a first group III-V semiconductor material;
a barrier layer provided on an upper surface of the channel layer, the barrier layer comprising a second group III-V semiconductor material that is different than the first group III-V semiconductor material;
a plurality of sources/drains spaced apart from each other on an upper surface of the barrier layer;
a gate insulating layer covering the upper surface of the barrier layer and upper surfaces of the plurality of sources/drains;
a gate provided on an upper surface of the gate insulating layer, the gate not overlapping the plurality of sources/drains;
a plurality of source/drain electrodes electrically connected to corresponding sources/drains among the plurality of sources/drains; and
a gate electrode electrically connected to the gate,
wherein the plurality of source/drain electrodes has a diagonally symmetrical arrangement.

2. The semiconductor device of claim 1, wherein the plurality of sources/drains comprises:
a first source/drain provided on a first quadrant of the upper surface of the barrier layer;
a second source/drain provided on a second quadrant of the upper surface of the barrier layer;
a third source/drain provided on a third quadrant of the upper surface of the barrier layer; and
a fourth source/drain provided on a fourth quadrant of the upper surface of the barrier layer.

3. The semiconductor device of claim 2, wherein the first source/drain, the second source/drain, the third source/drain, and the fourth source/drain do not cover a central area of the upper surface of the barrier layer, and optionally wherein the first source/drain and the fourth source/drain have a symmetrical shape with respect to a boundary between the first quadrant and the fourth quadrant,
wherein the first source/drain and the second source/drain have a symmetrical shape with respect to a boundary between the first quadrant and the second quadrant,
wherein the second source/drain and the third source/drain have a symmetrical shape with respect to a boundary between the second quadrant and the third quadrant, and
wherein the third source/drain and the fourth source/drain have a symmetrical shape with respect to a boundary between the third quadrant and the fourth quadrant.

4. The semiconductor device of claim 2 or 3, further comprising:
a first conductive layer provided on the upper surface of the gate insulating layer and electrically connected to the first source/drain;
a second conductive layer provided on the upper surface of the gate insulating layer and electrically connected to the second source/drain;
a third conductive layer provided on the upper surface of the gate insulating layer and electrically connected to the third source/drain; and
a fourth conductive layer provided on the upper surface of the gate insulating layer and electrically connected to the fourth source/drain, and optionally wherein the first conductive layer is in a vertex area of the first quadrant on the upper surface of the gate insulating layer,
wherein the second conductive layer is in a vertex area of the second quadrant on the upper surface of the gate insulating layer,
wherein the third conductive layer is in a vertex area of the third quadrant on the upper surface of the gate insulating layer, and
wherein the fourth conductive layer is in a vertex area of the fourth quadrant on the upper surface of the gate insulating layer.

5. The semiconductor device of claim 4, wherein the gate insulating layer comprises a plurality of openings that expose a portion of an upper surface of each of the first source/drain, the second source/drain, the third source/drain, and the fourth source/drain, and
wherein the first conductive layer, the second conductive layer, the third conductive layer, and the fourth conductive layer contact, through the plurality of openings, with the first source/drain, the second source/drain, the third source/drain, and the fourth source/drain, respectively.

6. The semiconductor device of any of claims 2 to 5, wherein the plurality of source/drain electrodes comprises:
a first source/drain electrode electrically connected to the first source/drain;
a second source/drain electrode electrically connected to the second source/drain;
a third source/drain electrode electrically connected to the third source/drain; and
a fourth source/drain electrode electrically connected to the fourth source/drain, and optionally wherein the gate electrode is in a central portion of the semiconductor device,
wherein the first source/drain electrode and the third source/drain electrode face each other in a first diagonal direction and are a first distance from a center of the gate electrode,
wherein the second source/drain electrode and the fourth source/drain electrode face each other in a second diagonal direction and are a second distance from the center of the gate electrode, and
wherein the second diagonal direction crosses the first diagonal direction, and the second distance is different from the first distance.

7. The semiconductor device of any preceding claim, wherein the gate comprises:
a central gate arranged in a central portion of the upper surface of the gate insulating layer; and
a plurality of branch gates extending between two adjacent sources/drains among the plurality of sources/drains, or wherein wherein each of the plurality of branch gates has a either a serpentine curve shape or a straight line shape.

8. The semiconductor device of claim 7, wherein the gate insulating layer covers a sidewall of the barrier layer and a sidewall of the channel layer.

9. The semiconductor device of any of claims 6 to 8, wherein each of the plurality of branch gates extends along a surface of the gate insulating layer to face the sidewall of the barrier layer and the sidewall of the channel layer.

10. The semiconductor device of any preceding claim, further comprising a passivation layer configured to cover the gate insulating layer and the gate,
wherein the gate electrode and the plurality of source/drain electrodes pass through the passivation layer.

11. The semiconductor device of an preceding claim, wherein the plurality of sources/drains comprises a first source/drain, a second source/drain, and a third source/drain that extend in a first direction,
wherein the first source/drain, the second source/drain, and the third source/drain are sequentially arranged in a second direction that is perpendicular to the first direction, and
wherein the gate comprises:
a first branch gate extending in the first direction between the first source/drain and the second source/drain; and
a second branch gate extending in the first direction between the second source/drain and the third source/drain.

12. An electronic apparatus comprising:
a substrate comprising a first semiconductor material;
a first semiconductor device provided on the substrate; and
a second semiconductor device according to any preceding provided on the substrate and comprising a second semiconductor material that is different than the first semiconductor material.

13. The electronic apparatus of claim 12, wherein the first semiconductor device is one of a transistor, a light-emitting device, or a sensor device.

14. The electronic apparatus of claim 12 or 13, wherein the substrate comprises a recessed groove in an upper surface of the substrate, and
wherein the second semiconductor device is provided in the groove such that the gate electrode and the plurality of source/drain electrodes face an outside of the groove.

15. The electronic apparatus of any of claims 12 to 14, wherein the gate electrode and the plurality of source/drain electrodes face an upper surface of the substrate.
